# EUROPEAN PATENT APPLICATION

(11) **EP 4 606 882 A1**
(43) Date of publication of application: **27.08.2025**
(21) Application number: 25157602.1
(22) Date of filing: 13.02.2025
(51) Int. Cl.: C11D 7/26, C11D 7/50, H01L 21/02

(54) **CLEANING SOLUTION, METHOD FOR CLEANING SUBSTRATE, AND METHOD FOR FORMING METAL-CONTAINING FILM**

(30) Priority: 20.02.2024 JP 2024023803
(71) Applicant: SHIN-ETSU CHEMICAL CO., LTD., Tokyo 1000005 (JP)
(72) Inventor: Kobayashi, Naoki, Niigata (JP); Ishiwata, Kenta, Niigata (JP)
(74) Representative: Sonnenhauser, Thomas Martin

(57) **Abstract**

The present invention is a cleaning solution for a composition for forming a metal-containing film, the cleaning solution containing: (A) a solvent; and (B) an organic acid, where the solvent (A) contains at least one kind of a first solvent (A-1) having a normal boiling point of lower than 160°C and at least one kind of a second solvent (A-2) having a normal boiling point of 160°C or higher and lower than 500°C. This can provide: a cleaning solution excellent in cleaning property, such as the removal of the metal-containing film on the periphery of a substrate, hump suppression property, and waste liquid stability when a composition for forming a metal-containing film is applied to the substrate; a method for cleaning a semiconductor substrate, using the cleaning solution; and a method for forming a metal-containing film, using the cleaning method.

## Description

### TECHNICAL FIELD

The present invention relates to a cleaning solution, a method for cleaning a substrate, and a method for forming a metal-containing film, and in particular, relates to a cleaning solution for a composition for forming a metal-containing film usable in a step of finely processing a semiconductor device or the like, a method for cleaning a semiconductor substrate, and a method for forming a resist underlayer film.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

On the other hand, in recent years, with the rapid miniaturization of DRAM memory, there is a growing need for further improvement in dry etching resistance, as well as a need for a resist underlayer film having excellent filling and planarizing properties. As a coating-type organic underlayer film composition excellent in filling and planarizing properties, for example, the composition disclosed in Patent Document 2 has been reported. However, in view of application of this composition in the advanced generation, there is a concern about dry etching resistance. The application limit of the conventional coating-type organic underlayer film compositions is thus approaching.

To solve the problems, there is consideration of the development of the use of a material containing a metal element for a resist underlayer film. By baking, ligands coordinated to metal atoms in a composition for forming a metal-containing film thermally decompose, hydrolysis and condensation progress, a metal oxide is formed, and a resist underlayer film excellent in dry etching resistance can be formed. Patent Document 3 reports that a material containing a Ti compound exhibits excellent dry etching resistance to CHF₃/CF₄-based gas and CO₂/N₂-based gas.

When a composition for forming a metal-containing film is used for a resist underlayer film, there is risk of a metal compound bonding to a surface of a substrate, such as a silicon wafer, when the composition for forming a metal-containing film is applied to the substrate and a residue being generated. To remove such a residue, there is a proposal to use a cleaning solution containing an organic solvent and a carboxylic acid (Patent Document 4). In addition, Patent Document 5 proposes a cleaning solution containing a solvent, an organic acid, and an additive that functions as a chelator.

One of the treatments performed in the process of forming a coating film pattern in a semiconductor wafer, being a substrate, is a peripheral coating film-removal (Edge Bead Removal: EBR) treatment, in which, after a composition for forming a coating film is applied to a surface of a substrate by spin-coating, the unnecessary film on the periphery of a coating film is removed in a ring-form. In this EBR treatment, a solvent of a coating film is discharged from a solvent nozzle locally onto the periphery of the wafer to be spin-coated. In the EBR treatment, on removing the film on the periphery of the coating film, it is required to suppress the generation of a bulge (hump) at the end portion of the coating film near the boundary of the region of the film to be removed in order to ensure a circuit pattern-formation region and increase the yield of the semiconductor device (Patent Document 6). In addition, in the formation of a metal-containing film by using a composition for forming a metal-containing film, it is necessary to consider not only cleaning property, such as the removal of the metal-containing film on the periphery of a substrate, but also suppression of humps.

Meanwhile, when considering practical use, when a multilayer resist process is performed with a single apparatus, waste liquids from multiple processes are often discharged through the same piping, and therefore, a cleaning solution is required to have waste liquid stability to suppress unintended phenomena such as the precipitation of metal in the piping due to interference with other waste liquids.

### CITATION LIST

### PATENT LITERATURE

Patent Document 1: JP2004-205685A
Patent Document 2: JP6714493B2
Patent Document 3: JP6342998B2
Patent Document 4: JP7065076B2
Patent Document 5: JP7274920B2
Patent Document 6: JP6879021B2

### SUMMARY OF INVENTION

### TECHNICAL PROBLEM

The present invention has been made in view of the above-described circumstances. An object of the present invention is to provide: a cleaning solution excellent in cleaning property, such as the removal of the metal-containing film on the periphery of a substrate, hump suppression property, and waste liquid stability when a composition for forming a metal-containing film is applied to the substrate; a method for cleaning a substrate, using the cleaning solution; and a method for forming a metal-containing film, using the cleaning method.

### SOLUTION TO PROBLEM

To achieve the object, the present invention provides a cleaning solution for a composition for forming a metal-containing film, the cleaning solution comprising:
(A) a solvent; and (B) an organic acid,
   wherein the solvent (A) contains at least one kind of a first solvent (A-1) having a normal boiling point of lower than 160°C and at least one kind of a second solvent (A-2) having a normal boiling point of 160°C or higher and lower than 500°C.

Such a cleaning solution can provide a cleaning solution excellent in cleaning property, such as the removal of the metal-containing film on the periphery of a substrate, hump suppression property, and waste liquid stability.

The second solvent (A-2) is preferably a chain ester, a chain ether, or a combination thereof.

When such a solvent is contained, it is possible to enhance the cleaning property, such as the removal of the metal-containing film on the periphery of a substrate, and hump suppression property.

In this case, the ester is preferably a carboxylate ester.

When such a solvent is contained, it is possible to enhance the cleaning property, such as the removal of the metal-containing film on the periphery of a substrate, and hump suppression property.

Alternatively, in this case, the ether is preferably a (poly)alkylene glycol dibenzyl ether or a (poly)phenyl ether.

When such a solvent is contained, it is possible to enhance the cleaning property, such as the removal of the metal-containing film on the periphery of a substrate, and hump suppression property.

The second solvent (A-2) preferably has a surface tension of 29.0 mN/m or more.

When such a solvent is contained, hump suppression property can be further enhanced.

In the solvent (A), it is preferable that the first solvent (A-1) is contained in an amount of 30 mass% or more and 98 mass% or less and the second solvent (A-2) is contained in an amount of 2 mass% or more and 70 mass% or less.

When such a solvent is contained, the removability of metal and hump suppression property can be further enhanced.

The organic acid (B) is preferably a carboxylic acid.

When the cleaning solution contains a carboxylic acid as the organic acid, the removability of metal can be further enhanced.

The organic acid (B) is preferably contained in an amount of 1 to 70 mass% based on an entire mass of the cleaning solution.

When the amount of the organic acid contained in the cleaning solution is in the above-described range, the removability of metal, the stability of the cleaning solution over time, and waste liquid stability can be further enhanced.

The cleaning solution preferably further comprises, as (C) a chelator, a compound having a β-diketone.

When the cleaning solution further contains the above-described chelator (C), the removability of metal can be further enhanced.

The chelator (C) is preferably contained in an amount of 0.1 to 10 mass% based on an entire mass of the cleaning solution.

When the amount of the chelator (C) contained in the cleaning solution is in the above-described range, the removability of metal, the stability of the cleaning solution over time, and waste liquid stability can be further enhanced.

The present invention also provides a method for cleaning a substrate comprising a step of cleaning, regarding a substrate coated directly or indirectly with a composition for forming a metal-containing film, the composition for forming a metal-containing film on a periphery of the substrate by using the above-described cleaning solution.

According to such a method for cleaning a substrate, it is possible to reduce the metal residue on a substrate generated when a composition for forming a metal-containing film is applied.

The present invention also provides a method for forming a metal-containing film, comprising the steps of:
coating a substrate directly or indirectly with a composition for forming a metal-containing film; and
cleaning the composition for forming a metal-containing film on a periphery of the substrate by using the above-described cleaning solution,
wherein the composition for forming a metal-containing film contains a metal compound and a solvent.

According to such a method for forming a metal-containing film, it is possible to reduce the metal residue on a substrate generated when a composition for forming a metal-containing film is applied, and therefore, the method can be used suitably in a step of forming a photoresist film or a resist underlayer film by using a composition for forming a metal-containing film.

### ADVANTAGEOUS EFFECTS OF INVENTION

As described above, the inventive cleaning solution contains (A) a solvent and (B) an organic acid, and the solvent (A) contains at least one kind of a first solvent (A-1) having a normal boiling point of lower than 160°C and at least one kind of a second solvent (A-2) having a normal boiling point of 160°C or higher and lower than 500°C. Therefore, when the composition for forming a metal-containing film on the periphery of the substrate is removed, drying of the cleaning solution is alleviated, and it is possible to increase the efficiency of the organic acid in removing the metal. Furthermore, since the cleaning solution has a high surface tension, the generation of humps can be suppressed. According to a method for cleaning a substrate, using the cleaning solution, and a method for forming a metal-containing film, using the cleaning solution, a desired metal-containing film can be formed efficiently, since a cleaning solution excellent in metal-cleaning property, hump suppression property, and waste liquid stability is used. These methods can be used suitably in the production and so forth of semiconductor devices, which are expected to be further miniaturized hereafter.

### BRIEF DESCRIPTION OF DRAWINGS

FIG. 1 is a flow diagram of an example in which a metal-containing film is formed on a substrate and the film on the peripheral edge is removed with the inventive cleaning solution in the present invention.
FIG. 2 is a flow diagram of an example in which a metal-containing film is formed on a substrate and the metal-containing film is removed with the inventive cleaning solution in the present invention.
FIG. 3 is a flow diagram of an example in which a pattern for forming a metal-containing resist underlayer film is formed in the present invention.
FIG. 4 is an explanatory diagram of a method for evaluating the height of a hump in the Examples.

### DESCRIPTION OF EMBODIMENTS

In a process of manufacturing a semiconductor device or the like, treatments performed in the process of forming a pattern for forming a metal-containing film include a peripheral coating film-removal (Edge Bead Removal: EBR) treatment of supplying a solvent to a substrate on a surface of which a metal-containing film has been formed to remove the unnecessary film on the coating-film periphery in a ring shape. In this EBR process, a cleaning solution is discharged from a solvent nozzle locally on the periphery of a rotating substrate.

In the EBR treatment of a metal-containing film, there have been demands for: a cleaning solution excellent in metal-cleaning property, such as the removal of the metal-containing film on the periphery of a substrate when a composition for forming a metal-containing film is applied to the substrate, and excellent in stability when mixed with another waste liquid; a method for cleaning a semiconductor substrate, using the cleaning solution; and a method for forming a resist underlayer film, using the cleaning method.

Conventionally, a cleaning solution containing an organic solvent and a carboxylic acid has been used, but there has been room for improvement in metal-removability, hump suppression property, and waste liquid stability.

The present inventors have found out that the above-described problems can be improved by a cleaning solution for a composition for forming a metal-containing film, the cleaning solution containing: (A) a solvent; and (B) an organic acid, where the solvent (A) contains at least one kind of a first solvent (A-1) having a normal boiling point of lower than 160°C and at least one kind of a second solvent (A-2) having a normal boiling point of 160°C or higher and lower than 500°C. Thus, the present invention has been completed.

That is, the present invention is a cleaning solution for a composition for forming a metal-containing film, the cleaning solution comprising:
(A) a solvent; and (B) an organic acid,
   wherein the solvent (A) contains at least one kind of a first solvent (A-1) having a normal boiling point of lower than 160°C and at least one kind of a second solvent (A-2) having a normal boiling point of 160°C or higher and lower than 500°C.

Hereinafter, the present invention will be described in detail, but the present invention is not limited thereto.

### <Cleaning Solution>

The inventive cleaning solution contains (A) a solvent and (B) an organic acid, and the solvent (A) contains at least one kind of a first solvent (A-1) having a normal boiling point of lower than 160°C and at least one kind of a second solvent (A-2) having a normal boiling point of 160°C or higher and lower than 500°C. The inventive cleaning solution can be used for cleaning a substrate coated with a composition for forming a metal-containing film.

### (Solvent (A))

The solvent (A) contains a first solvent (A-1) component and a second solvent (A-2) component. The solvent (A) may contain another solvent component other than the first solvent (A-1) component and the second solvent (A-2) component. One kind or a combination of two or more kinds of each of the solvent components may be used.

The cleaning solution contains the solvent (A) in addition to the organic acid (B) described later, and the solvent (A) contains a first solvent (A-1) having a normal boiling point of lower than 160°C and a second solvent (A-2) having a normal boiling point of 160°C or higher and lower than 500°C. Therefore, the cleaning solution is excellent in: metal-cleaning property, such as the removal of the metal-containing film on the periphery of a substrate when a composition for forming a metal-containing film is applied to the substrate; hump suppression property; and stability when mixed with other waste liquids.

The reason why the cleaning solution can achieve the above-described advantageous effects by including the above-described features is not necessarily clear, but can be conjectured to be as follows, for example.

In the present invention, when a metal-containing film is to be removed, a substrate coated with the metal-containing film is rotated and a cleaning solution is discharged from a solvent nozzle locally onto a peripheral edge of the coating film, and thus, the coating film on the periphery is removed. That is, it is considered that, when a mixture of a first solvent (A-1) component, having a low boiling point, and a second solvent (A-2) component, having a high boiling point, is contained as the solvent (A), drying of the cleaning solution is alleviated, and therefore, the organic acid acts effectively on the metal-containing film on the peripheral edge and the removability of the metal is enhanced. In addition, when an EBR treatment is performed, the coating film is softened and dissolved by the cleaning solution in the region to which the cleaning solution has been supplied, and a mixed layer of the coating film and the cleaning solution is formed. When the cleaning solution has a low surface tension, the cleaning solution spreads easily on the substrate, and therefore, easily permeates from the mixed layer to the coating film side. It is thought that, for this reason, the mixed layer is pushed up in the vicinity of the boundary with the coating film edge, generating a hump-shaped bulge. It can be considered that, by containing the second solvent (A-2), the inventive cleaning solution has a high surface tension, so that it is difficult for the cleaning solution to permeate to the side of the coating film edge, and thus, the generation of a hump is suppressed.

In the following, each solvent component will be described in detail.

### [First Solvent (A-1)]

The first solvent (A-1) component is a solvent having a normal boiling point of lower than 160°C.

The upper limit of the normal boiling point of the first solvent (A-1) component is preferably 158°C, more preferably 156°C. The lower limit of the normal boiling point is preferably 100°C, more preferably 120°C. When the first solvent (A-1) component has a normal boiling point in the above ranges, it is possible to enhance the stability over time and waste liquid stability of the cleaning solution.

Examples of the first solvent (A-1) component include alcohols, esters, ethers, and ketones.

Examples of the alcohols include: monoalcohols, such as methanol (boiling point: 65°C), ethanol (boiling point: 78°C), n-propanol (boiling point: 97°C), isopropanol (boiling point: 82°C), n-butanol (boiling point: 117°C), iso-butanol (boiling point: 108°C), sec-butanol (boiling point: 99°C), tert-butanol (boiling point: 82°C), n-pentanol (boiling point: 138°C), isopentanol (boiling point: 132°C), 2-methylbutanol (boiling point: 136°C), sec-pentanol (boiling point: 118°C), tert-pentanol (boiling point: 102°C), 2-methylpentanol (boiling point: 148°C), 2-ethylbutanol (boiling point: 146°C), 3-methoxybutanol (boiling point: 157°C), and n-hexanol (boiling point: 157°C); and alkylene glycol monoalkyl ethers, such as ethylene glycol monomethyl ether (boiling point: 125°C), ethylene glycol monoethyl ether (boiling point: 135°C), propylene glycol monomethyl ether (boiling point: 121°C), propylene glycol monoethyl ether (boiling point: 133°C), and propylene glycol monopropyl ether (boiling point: 149.8°C) .

Examples of the esters include carboxylate esters. Examples of the carboxylate esters include: acetate esters, such as butyl acetate (boiling point: 151°C); propionate esters, such as iso-amyl propionate (boiling point: 156°C); and lactate esters, such as ethyl lactate (boiling point: 151°C).

Examples of the ethers include: alkylene glycol monoalkyl ether acetates, such as ethylene glycol monomethyl ether acetate (boiling point: 145°C) and propylene glycol monomethyl ether acetate (boiling point: 146°C).

Examples of the ketones include 2-heptanone (boiling point: 151°C).

As the first solvent (A-1) component, esters and/or ethers are preferable among the above from the viewpoint of compatibility with the organic acid (B), chain esters and/or chain ethers are more preferable, carboxylate esters, alkylene glycol monoalkyl ether, and/or alkylene glycol monoalkyl ether acetates are more preferable, lactate esters, alkylene glycol monoalkyl ethers, and/or alkylene glycol monoalkyl ether acetates are further preferable, and propylene glycol monomethyl ether acetate (PGMEA) is particularly preferable.

The lower limit of the amount of the first solvent (A-1) component to be contained in the solvent (A) is preferably 30 mass%, more preferably 35 mass%, and further preferably 50 mass%. The upper limit of the amount to be contained is preferably 98 mass%, more preferably 97 mass%, and further preferably 96 mass%. When the amount of the first solvent (A-1) to be contained is in the above ranges, the stability over time and waste liquid stability of the cleaning solution can be enhanced.

### [Second Solvent (A-2)]

The second solvent (A-2) component is a solvent having a normal boiling point of 160°C or higher and lower than 500°C.

The lower limit of the normal boiling point of the second solvent (A-2) component is preferably 170°C, more preferably 180°C, and further preferably 190°C. The upper limit of the normal boiling point is preferably lower than 500°C, more preferably 450°C, further preferably 400°C, and particularly preferably 350°C. When the second solvent (A-2) component has a normal boiling point in the above ranges, it is possible to enhance the metal-removability, hump suppression property, stability over time, and waste liquid stability of the cleaning solution.

Examples of the second solvent (A-2) component include esters, alcohols, ethers, carbonates, ketones, and amides.

Examples of the esters include, for example, carboxylate esters including: acetate esters, such as 2-ethylbutyl acetate (boiling point: 160°C), 2-ethylhexyl acetate (boiling point: 199°C), benzyl acetate (boiling point: 212°C), cyclohexyl acetate (boiling point: 172°C), methylcyclohexyl acetate (boiling point: 201°C), n-nonyl acetate (boiling point: 208°C), 1,6-diacetoxyhexane (boiling point: 260°C); acetoacetate esters, such as methyl acetoacetate (boiling point: 169°C) and ethyl acetoacetate (boiling point: 181°C); propionate esters, such as iso-amyl propionate (boiling point: 161°C); oxalate esters, such as diethyl oxalate (boiling point: 185°C) and di-n-butyl oxalate (boiling point: 239°C); lactate esters, such as n-butyl lactate (boiling point: 185°C); malonate esters, such as diethyl malonate (boiling point: 199°C); phthalate esters, such as dimethyl phthalate (boiling point: 283°C); and lactones, such as β-propiolactone (boiling point: 162°C), γ-butyrolactone (boiling point: 204°C), γ-valerolactone (boiling point: 207°C), γ-undecalactone (boiling point: 286°C).

Examples of the alcohols include: monoalcohols, such as n-octanol (boiling point: 194°C), sec-octanol (boiling point: 174°C), n-nonyl alcohol (boiling point: 215°C), n-decanol (boiling point: 228°C), phenol (boiling point: 182°C), cyclohexanol (boiling point: 161°C), and benzyl alcohol (boiling point: 205°C); polyhydric alcohols, such as ethylene glycol (boiling point: 197°C), 1,2-propylene glycol (boiling point: 188°C), 1,3-butylene glycol (boiling point: 208°C), 2,4-pentanediol (boiling point: 201°C), 2-methyl-2,4-pentanediol (boiling point: 196°C), 2,5-hexanediol (boiling point: 216°C), triethylene glycol (boiling point: 165°C), and dipropylene glycol (boiling point: 230°C); and polyhydric alcohol partial ethers, such as ethylene glycol monobutyl ether (boiling point: 171°C), ethylene glycol monophenyl ether (boiling point: 244°C), diethylene glycol monomethyl ether (boiling point: 194°C), diethylene glycol monoethyl ether (boiling point: 202°C), triethylene glycol monomethyl ether (boiling point: 249°C), diethylene glycol monoisopropyl ether (boiling point: 207°C), diethylene glycol monobutyl ether (boiling point: 231°C), triethylene glycol monobutyl ether (boiling point: 271°C), ethylene glycol monoisobutyl ether (boiling point: 161°C), diethylene glycol monoisobutyl ether (boiling point: 220°C), ethylene glycol monohexyl ether (boiling point: 208°C), diethylene glycol monohexyl ether (boiling point: 259°C), ethylene glycol mono-2-ethylhexyl ether (boiling point: 229°C), diethylene glycol mono-2-ethylhexyl ether (boiling point: 272°C), ethylene glycol monoallyl ether (boiling point: 161°C), diethylene glycol monophenyl ether (boiling point: 283°C), ethylene glycol monobenzyl ether (boiling point: 256°C), diethylene glycol monobenzyl ether (boiling point: 302°C), dipropylene glycol monomethyl ether (boiling point: 187°C), tripropylene glycol monomethyl ether (boiling point: 242°C), dipropylene glycol monopropyl ether (boiling point: 212°C), propylene glycol monobutyl ether (boiling point: 170°C), dipropylene glycol monobutyl ether (boiling point: 231°C), and propylene glycol monophenyl ether (boiling point: 243°C).

Examples of the ethers include: dialkylene glycol monoalkyl ether acetates, such as dipropylene glycol monomethyl ether acetate (normal boiling point: 213°C), diethylene glycol monoethyl ether acetate (boiling point: 217°C), and diethylene glycol monobutyl ether acetate (normal boiling point: 247°C); alkylene glycol monoalkyl ether acetates, such as butylene glycol monomethyl ether acetate (boiling point: 172°C) and ethylene glycol monobutyl ether acetate (boiling point: 188°C); dialkylene glycol dialkyl ethers, such as diethylene glycol dimethyl ether (boiling point: 162°C), diethylene glycol methyl ethyl ether (boiling point: 176°C), diethylene glycol diethyl ether (boiling point: 189°C), diethylene glycol dibutyl ether (boiling point: 255°C), and dipropylene glycol dimethyl ether (boiling point: 171°C); trialkylene glycol dialkyl ethers, such as triethylene glycol dimethyl ether (boiling point: 216°C); tetraalkylene glycol dialkyl ethers, such as tetraethylene glycol dimethyl ether (boiling point: 275°C); 1,8-cineole (boiling point: 176°C); diisopentyl ether (boiling point: 171°C); ethyl benzyl ether (boiling point: 189°C); diphenyl ether (boiling point: 259°C); dibenzyl ether (boiling point: 297°C); and hexyl ether (boiling point: 226°C).

Examples of the carbonates include ethylene carbonate (boiling point: 244°C) and propylene carbonate (boiling point: 242°C).

Examples of the ketones include ethyl amyl ketone (boiling point: 167°C), dibutyl ketone (boiling point: 186°C), and diamyl ketone (boiling point: 228°C).

Examples of the amides include N-methylpyrrolidone (boiling point: 204°C), N,N-dimethylacetamide (boiling point: 165°C), formamide (boiling point: 210°C), N-ethylacetamide (boiling point: 206°C), and N-methylacetamide (boiling point: 206°C).

Other examples of the second solvent (A-2) component include furfural (boiling point: 162°C), dimethyl sulfoxide (boiling point: 189°C), sulfolane (boiling point: 287°C), glycerin (boiling point: 290°C), succinonitrile (boiling point: 265°C), and nitrobenzene (boiling point: 211°C).

As the second solvent (A-2) component, esters, alcohols, ethers, and/or carbonates are preferable among the above, and chain esters, chain ethers, and combinations thereof are more preferable.

As the esters, carboxylate esters are preferable. As the ethers, (poly)alkylene glycol dibenzyl ethers and (poly)phenyl ethers are preferable.

Examples of preferable structures include the following.
(i) (Poly)ethylene glycol dibenzoate
(ii) (Poly)ethylene glycol dibenzyl ether
(iii) (Poly)propylene glycol dibenzyl ether
(iv) (Poly)butylene glycol dibenzyl ether
(v) Linear aliphatic dibenzyl dicarboxylate
(vi) (Poly)phenyl ether

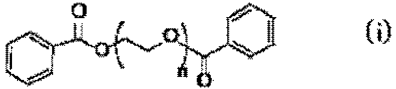

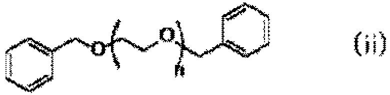

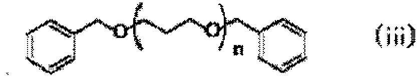

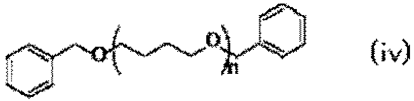

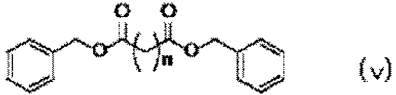

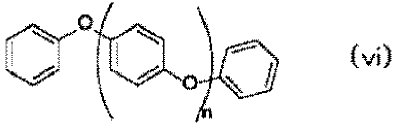

In the formulae, "n" represents a repeating unit number, and for example, "n" is 1 to 100.

The second solvent (A-2) preferably has a surface tension of 29.0 mN/m or more, more preferably 30.0 mN/m or more, and further preferably 31.0 mN/m or more. Furthermore, the upper limit of the surface tension of the second solvent (A-2) is not particularly limited, but can be, for example, 50.0 mN/m or less. When a solvent having such a surface tension is contained as the second solvent, the hump suppression property of the cleaning solution can be further enhanced.

Examples of the second solvent (A-2) component having a normal boiling point of 160°C or higher and lower than 500°C and having a surface tension value in the above ranges include the following.

Propyl benzoate (boiling point: 230°C, surface tension: 34.8 mN/m), butyl benzoate (boiling point: 250°C, surface tension: 34.2 mN/m), benzyl benzoate (boiling point: 324°C, surface tension: 43.4 mN/m), diethylene glycol dibenzoate (boiling point: 236°C, surface tension: 45.5 mN/m), bis(2-ethylhexyl) sebacate (boiling point: 377°C, surface tension: 31.9 mN/m), 1,6-diacetoxyhexane (boiling point: 260°C, surface tension: 34.8 mN/m), γ-butyrolactone (boiling point: 204°C, surface tension: 44.8 mN/m), diethylene glycol monobenzyl ether (boiling point: 302°C, surface tension: 42.9 mN/m), and tripropylene glycol monomethyl ether (boiling point: 242°C, surface tension: 30.5 mN/m). As the surface tension, the result obtained by measuring the surface tension of the solvent by using a du Noüy-type surface tension tester type D (manufactured by Ito Seisakusho Co., Ltd) is shown.

The lower limit of the amount of the second solvent (A-2) component to be contained in the solvent (A) is preferably 2 mass%, more preferably 3 mass%, further preferably 4 mass%, particularly preferably 4 mass%, and further particularly preferably 8 mass%. The upper limit of the amount to be contained is preferably 70 mass%, more preferably 65 mass%, further preferably 50 mass%, particularly preferably 30 mass%, and further particularly preferably 20 mass%. When the amount of the second solvent (A-2) to be contained is in the above ranges, the metal-removability, hump suppression property, stability over time, and waste liquid stability of the cleaning solution can be highly enhanced.

In the inventive cleaning solution, it is particularly preferable that, in the solvent (A), the first solvent (A-1) is contained in an amount of 30 mass% or more and 98 mass% or less and the second solvent (A-2) is contained in an amount of 2 mass% or more and 70 mass% or less.

### (Organic Acid (B))

The inventive cleaning solution preferably contains (B) an organic acid. When the cleaning solution contains the organic acid (B), removability of a metal-containing film formed on a substrate is improved.

Examples of the organic acid (B) include carboxylic acid, sulfonic acid, sulfinic acid, organic phosphinic acid, organic phosphonic acid, phenol, enol, thiol, acid imide, oxime, sulfonamide, etc.

The organic acid (B) is preferably a carboxylic acid. More specific examples include: carboxylic acids including an aliphatic saturated hydrocarbon group and/or aromatic hydrocarbon group and a carboxy group, for example, formic acid, acetic acid, propionic acid, butanoic acid (butyric acid), isobutanoic acid (isobutyric acid), pentanoic acid, hexanoic acid, 2-ethylhexanoic acid, cyclohexanecarboxylic acid, cyclohexylacetic acid, 1-adamantanecarboxylic acid, benzoic acid, and phenylacetic acid; fluorine atom-containing monocarboxylic acids, such as difluoroacetic acid, trifluoroacetic acid, pentafluoropropanoic acid, heptafluorobutanoic acid, fluorophenylacetic acid, and difluorobenzoic acid; monocarboxylic acids containing a group containing a heteroatom other than a fluorine atom in a moiety other than a carboxy group, for example, 10-hydroxydecanoic acid, 5-oxohexanoic acid, 3-methoxycyclohexanecarboxylic acid, camphorcarboxylic acid, dinitrobenzoic acid, nitrophenylacetic acid, lactic acid, glycolic acid, glyceric acid, salicylic acid, anisic acid, gallic acid, and furancarboxylic acid; unsaturated monocarboxylic acids, such as acrylic acid, methacrylic acid, crotonic acid, isocrotonic acid, 3-butenoic acid, angelic acid, tiglic acid, 4-pentenoic acid, cinnamic acid, sorbic acid, propiolic acid, and 2-butynoic acid; polycarboxylic acids including a single bond, an aliphatic saturated hydrocarbon group and/or aromatic hydrocarbon group and multiple carboxy groups, for example, oxalic acid, malonic acid, succinic acid, glutaric acid, adipic acid, dodecanedicarboxylic acid, propanetricarboxylic acid, butanetetracarboxylic acid, cyclohexanehexacarboxylic acid, 1,4-naphthalenedicarboxylic acid, phthalic acid, isophthalic acid, terephthalic acid, trimellitic acid, pyromellitic acid, and 1,2,3,4-cyclobutanetetracarboxylic acid; partially esterified products of the polycarboxylic acids; fluorine atom-containing polycarboxylic acids, such as difluoromalonic acid, tetrafluorophthalic acid, and hexafluoroglutaric acid; polycarboxylic acids containing a heteroatom other than a fluorine atom in a moiety other than a carboxy group, for example, tartaric acid, citric acid, malic acid, tartronic acid, diglycolic acid, and iminodiacetic acid; unsaturated polycarboxylic acids, such as maleic acid, fumaric acid, and aconitic acid; etc.

From the viewpoints of cleaning property and waste liquid stability, the organic acid (B) is further preferably at least one selected from the group consisting of formic acid, acetic acid, citric acid, oxalic acid, 2-ethylhexanoic acid, dodecanoic acid, ascorbic acid, tartaric acid, glucuronic acid, methanesulfonic acid, benzenesulfonic acid, p-toluenesulfonic acid, acrylic acid, methacrylic acid, crotonic acid, isocrotonic acid, and 3-butenoic acid.

The lower limit of the proportion of the organic acid (B) contained relative to all the components contained in the cleaning solution is preferably 1 mass%, more preferably 1.5 mass%, further preferably 2 mass%, and particularly preferably 3 mass%. The upper limit of the contained proportion is preferably 70 mass%, more preferably 60 mass%, further preferably 55 mass%, and particularly preferably 50 mass%. When the proportion of the organic acid contained is in the above ranges, cleaning property and waste liquid stability can be further enhanced.

In the inventive cleaning solution, the organic acid (B) is preferably contained in an amount of 1 to 70 mass% based on an entire mass of the cleaning solution.

### (Chelator (C))

The inventive cleaning solution may also contain (C) a chelator for further enhancing metal-removability. As the chelator, a compound having a β-diketone structure is preferable from the viewpoint of cleaning property. Specific examples include 2,4-pentadione (acetylacetone), 3-methyl-2,4-pentadione, 3-ethyl-2,4-pentadione, acetoacetic acid ester, allyl acetoacetate, α-alkyl-substituted acetoacetic acid esters, β-ketopentanoic acid esters, benzoylacetic acid esters, and 1,3-acetonedicarboxylic acid esters.

Furthermore, in the inventive cleaning solution, the chelator (C) is preferably contained in an amount of 0.1 to 10 mass% based on an entire mass of the cleaning solution.

### (Other Components)

The inventive cleaning solution may also contain other components in addition to the above-described components. Examples of the other components include inorganic hydrofluoric acids, tetraalkylammonium compounds, and surfactants.

Examples of inorganic hydrofluoric acids include hexafluorosilicic acid, hexafluorophosphoric acid, and fluoroboric acid.

Examples of tetraalkylammonium compounds include tetramethylammonium fluoride, tetrabutylammonium fluoride, and tetrabutylammonium fluorosilicate.

Examples of surfactants include those disclosed in paragraphs [0142] to [0147] of JP2009-269953A.

Regarding each additive, one kind may be used, or two or more kinds may be used in combination. In the inventive cleaning solution, the amount of the additives to be contained is preferably 0 to 10 mass% based on the entire mass of the cleaning solution.

### <Method for Preparing Cleaning Solution>

The inventive cleaning solution can be prepared by mixing a solvent (A), an organic acid (B), and as necessary, a chelator (C) and optional components in predetermined proportions, and preferably filtering the obtained mixture through a membrane filter with a pore size of 0.5 µm or less or the like.

### <Method for Cleaning Substrate and Method for Forming Metal-Containing Film>

The inventive cleaning solution can be used for removing a metal-containing film on the periphery of a substrate when the composition for forming a metal-containing film has been applied to the substrate and so forth.

Accordingly, the present invention provides a method for cleaning a substrate including a step of cleaning, regarding a substrate coated directly or indirectly with a composition for forming a metal-containing film, the composition for forming a metal-containing film on a periphery of the substrate by using the inventive cleaning solution.

Furthermore, the present invention provides a method for forming a metal-containing film, including the steps of:
coating a substrate directly or indirectly with a composition for forming a metal-containing film (coating step); and
cleaning the composition for forming a metal-containing film on a periphery of the substrate by using the inventive cleaning solution (cleaning step),
where the composition for forming a metal-containing film contains a metal compound and a solvent.

When the composition for forming a metal-containing film is a material for a resist underlayer film, after the cleaning step, it is preferable to perform further, as a resist patterning process, the steps of: forming a photoresist film directly or indirectly on the metal-containing film formed in the coating step; subjecting the photoresist film to exposure; forming a photoresist pattern by development; and transferring the resist pattern directly or indirectly to the metal-containing film by etching while using the resist pattern as a mask. In the following, this method is also referred to as a "method for manufacturing a semiconductor substrate", including these steps.

When the composition for forming a metal-containing film is a material for a photoresist film, after the cleaning step, it is preferable to include the steps of: subjecting the photoresist film to exposure; forming a photoresist pattern by development; and transferring the resist pattern directly or indirectly to the substrate by etching while using the resist pattern as a mask.

The periphery of the substrate means, for example, the peripheral portion of the substrate that is within a length of 3.0 cm from the peripheral edge of the substrate towards the center of the substrate. The length from the peripheral edge of the substrate towards the center of the substrate can be 2.0 cm, 1.0 cm, 0.5 cm, or 0.2 cm.

When the composition for forming a metal-containing film is a material for a resist underlayer film, the method for manufacturing a semiconductor substrate may further include, as necessary, before the resist patterning process, a step of forming an organic resist middle layer film directly or indirectly on the substrate having the metal-containing film formed in the coating step (step of forming organic resist middle layer film).

When the composition for forming a metal-containing film is a material for a resist underlayer film, the method for manufacturing a semiconductor substrate may further include, as necessary, before the resist patterning process, a step of forming a silicon-containing film directly or indirectly on the substrate having the metal-containing film formed in the coating step (step of forming silicon-containing film).

In the following, descriptions will be given regarding the composition for forming a metal-containing film and cleaning solution to be used in the method for manufacturing a semiconductor substrate, and each of the steps when the step of forming organic resist middle layer film and step of forming silicon-containing film, being optional steps, are included.

### <Composition for Forming Metal-Containing Film>

Compositions for forming a metal-containing film to which the inventive cleaning solution is applicable are not particularly limited as long as (M) a metal compound and (B) a solvent are contained. The composition may also contain other optional components. The composition for forming a metal-containing film is preferably a material usable as a photoresist film or a resist underlayer film.

The metal compound (M) is preferably a compound containing a metal atom and an oxygen atom. Examples of the metal atom contained in the metal compound (M) include metal atoms of the group 3 to 16 of the periodic table (excluding a silicon atom). As the metal compound (M), one kind of metal atom may be contained, or two or more kinds may be contained.

Examples of metal atoms of the group 3 include scandium, yttrium, lanthanum, and cerium.

Examples of metal atoms of the group 4 include titanium, zirconium, and hafnium.

Examples of metal atoms of the group 5 include vanadium, niobium, and tantalum.

Examples of metal atoms of the group 6 include chromium, molybdenum, and tungsten.

Examples of metal atoms of the group 7 include manganese and rhenium.

Examples of metal atoms of the group 8 include iron, ruthenium, and osmium.

Examples of metal atoms of the group 9 include cobalt, rhodium, and iridium.

Examples of metal atoms of the group 10 include nickel, palladium, and platinum.

Examples of metal atoms of the group 11 include copper, silver, and gold.

Examples of metal atoms of the group 12 include zinc, cadmium, and mercury.

Examples of metal atoms of the group 13 include aluminum, gallium, and indium.

Examples of metal atoms of the group 14 include germanium, tin, and lead.

Examples of metal atoms of the group 15 include antimony and bismuth.

Examples of metal atoms of the group 16 include tellurium.

As the metal atom to be contained in the metal compound (M), metal atoms of the group 3 to the group 16 are preferable, metal atoms of the group 4 to the group 14 are more preferable, metal atoms of the group 4, the group 5, and the group 14 are further preferable, and metal atoms of the group 4 are particularly preferable. Specifically, preferable are titanium, chromium, manganese, iron, cobalt, nickel, copper, zinc, zirconium, molybdenum, indium, tin, hafnium, tantalum, tungsten, bismuth, and combinations thereof.

As a component contained in the metal compound (M) other than the metal atom, it is preferable that the compound contains a hydrolysable group or one or more ligands derived from organic acids (hereinafter, also referred to as "organic acid (a)"), hydroxy acid esters, β-diketones, β-keto esters, α,α-dicarboxylic acid esters, amines, amides, olefins, hydrocarbons having a π bond, and compounds containing diphosphines. Here, "organic acid" indicates an organic compound that exhibits acidity, and "organic compound" indicates a compound having at least one carbon atom. Ways in which the organic acid (a) can be contained also include organic acid anions obtained by removing a hydrogen ion from the organic acid (a).

Examples of the hydrolysable group include halogen atoms, alkoxy groups, acyloxy groups, etc.

Examples of the halogen atoms include a fluorine atom, a chlorine atom, a bromine atom, an iodine atom, etc.

As the alkoxy groups, alkoxy groups having 1 to 10 carbon atoms are preferable, and examples include a methoxy group, an ethoxy group, an n-propoxy group, an i-propoxy group, a butoxy group, an octyl group, etc.

Examples of the acyloxy groups include an acetoxy group, an ethylyloxy group, a propionyloxy group, a butyryloxy group, a t-butyryloxy group, a t-amylyloxy group, an n-hexanecarbonyloxy group, an n-octanecarbonyloxy group, etc.

As the hydrolysable group, alkoxy groups and acyloxy groups are preferable, and an n-propoxy group, an i-propoxy group, a butoxy group, and an octyl group are more preferable.

Examples of the organic acid (a) include carboxylic acid, sulfonic acid, sulfinic acid, organic phosphinic acid, organic phosphonic acid, phenol, enol, thiol, acid imide, oxime, sulfonamide, etc.

Examples of the carboxylic acid include: monocarboxylic acids, such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids, such as oxalic acid, malonic acid, maleic acid, methylmalonic acid, fumaric acid, adipic acid, sebacic acid, phthalic acid, and tartaric acid; and carboxylic acids having three or more carboxy groups, such as citric acid.

Examples of the sulfonic acid include benzenesulfonic acid and p-toluenesulfonic acid.

Examples of the sulfinic acid include benzenesulfinic acid and p-toluenesulfinic acid.

Examples of the organic phosphinic acid include diethylphosphinic acid, methylphenylphosphinic acid, and diphenylphosphinic acid.

Examples of the organic phosphonic acid include methylphosphonic acid, ethylphosphonic acid, t-butylphosphonic acid, cyclohexylphosphonic acid, and phenylphosphonic acid.

Examples of the phenol include: monohydric phenols, such as phenol, cresol, 2,6-xylenol, and naphthol; dihydric phenols, such as catechol, resorcinol, hydroquinone, and 1,2-naphthalenediol; and phenols having a valency of three or more, such as pyrogallol, 2,3,6-naphthalenetriol.

Examples of the enol include 2-hydroxy-3-methyl-2-butene and 3-hydroxy-4-methyl-3-hexene.

Examples of the thiol include mercaptoethanol and mercaptopropanol.

Examples of the acid imides include: carboxylic acid imides, such as maleimide and succinimide; and sulfonic imides, such as di(trifluoromethanesulfonic acid)imide and di(pentafluoroethanesulfonic acid)imide.

Examples of the oxime include: aldoximes, such as benzaldoxime and salicylaldoxime; and ketoximes, such as diethylketoxime, methylethylketoxime, and cyclohexanone oxime.

Examples of the sulfonamide include methylsulfonamide, ethylsulfonamide, benzenesulfonamide, and toluenesulfonamide.

As the organic acid (a), carboxylic acids having 1 to 10 carbon atoms are preferable.

Examples of the hydroxy acid esters include glycolic acid esters, lactic acid esters, 2-hydroxycyclohexane-1-carboxylic acid esters, salicylic acid esters, etc.

Examples of the β-diketones include 2,4-pentanedione, 3-methyl-2,4-pentanedione, 3-ethyl-2,4-pentanedione, etc.

Examples of the β-keto esters include acetoacetic acid esters, α-alkyl-substituted acetoacetic acid esters, β-ketopentanoic acid esters, benzoylacetic acid esters, 1,3-acetonedicarboxylic acid esters, etc.

Examples of the α,α-dicarboxylic acid esters include malonic acid diesters, α-alkyl-substituted malonic acid diesters, α-cycloalkyl-substituted malonic acid diesters, α-aryl-substituted malonic acid diesters, etc.

Examples of compounds containing amine include pyridine, trimethylamine, piperidine, diethanolamine, triethanolamine, etc.

Examples of compounds containing amide include compounds containing unsubstituted amide (NH₂), methylamide (NHMe), dimethylamide (NMe₂), diethylamide (NEt₂), dipropylamide (NPr₂), etc.

Examples of compounds containing olefin include: chain olefins, such as ethylene and propylene; cyclic olefins, such as cyclopentene, cyclohexene, and norbornene; etc.

Examples of the hydrocarbons having a π bond include: chain dienes, such as butadiene and isoprene; cyclic dienes, such as cyclopentadiene, methylcyclopentadiene, pentamethylcyclopentadiene, cyclohexadiene, and norbornadiene; aromatic hydrocarbons, such as benzene, toluene, xylene, hexamethylbenzene, naphthalene, and indene; etc.

Examples of the compounds containing diphosphines include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino)ferrocene, etc.

Examples of the metal compound (M) include compounds represented by the following formula (M-1). By using such a metal compound (M-1), a stable metal compound (M) can be formed, and dry etching resistance can be enhanced.

LₐM(=O)_{b}X_{c} (M-1)

In the formula, M represents any of titanium, chromium, manganese, iron, cobalt, nickel, copper, zinc, zirconium, molybdenum, indium, tin, hafnium, tantalum, tungsten, and bismuth. L represents a monodentate ligand or polydentate ligand having 1 to 30 carbon atoms, and X represents a hydrolysable group selected from a halogen atom, an alkoxy group, a carboxylate group, an acyloxy group, and -NR^{a}R^{b}. R^{a} and R^{b} each independently represent a hydrogen atom or a monovalent organic group having 1 to 20 carbon atoms. a+c is 1 to 6, "a" represents an integer of 0 to 4, "b" represents an integer of 0 to 2, and "c" represents an integer of 0 to 6.

Examples of the hydrolysable group X of the formula (M-1) include halogen atoms, alkoxy groups, carboxylate groups, acyloxy groups, and -NR^{a}R^{b}. R^{a} and R^{b} preferably each independently represent a hydrogen atom or a monovalent organic group having 1 to 20 carbon atoms.

Examples of the halogen atoms include a fluorine atom, a chlorine atom, a bromine atom, an iodine atom, etc.

Examples of the alkoxy groups include a methoxy group, an ethoxy group, an n-propoxy group, an i-propoxy group, an n-butoxy group, a t-butoxy group, etc.

Examples of the carboxylate groups include: monocarboxylic acids, such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids, such as oxalic acid, malonic acid, maleic acid, methylmalonic acid, fumaric acid, adipic acid, sebacic acid, phthalic acid, and tartaric acid; and ligands derived from carboxylic acids having three or more carboxy groups, such as citric acid.

Examples of the acyloxy groups include an acetoxy group, an ethylyloxy group, a propionyloxy group, a butyryloxy group, a t-butyryloxy group, a t-amylyloxy group, an n-hexanecarbonyloxy group, an n-octanecarbonyloxy group, etc.

Examples of the -NR^{a}R^{b} include an unsubstituted amino group, a methylamino group, a dimethylamino group, a diethylamino group, a dipropylamino group, etc.

As the hydrolysable group X, an alkoxy group is preferable, and an i-propoxy group, an n-butoxy group, or a t-butoxy group is more preferable.

### (Monodentate Ligand)

Examples of the monodentate ligand L include a hydroxo ligand, carboxy ligands, amido ligands, amine ligands, olefin ligands, etc.

Examples of the carboxy ligands include: monocarboxylic acids, such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids, such as oxalic acid, malonic acid, maleic acid, methylmalonic acid, fumaric acid, adipic acid, sebacic acid, phthalic acid, and tartaric acid; and ligands derived from carboxylic acids having three or more carboxy groups, such as citric acid.

Examples of the amido ligands include an unsubstituted amido ligand (NH₂), a methylamido ligand (NHMe), a dimethylamido ligand (NMe₂), a diethylamido ligand (NEt₂), a dipropylamido ligand (NPr₂), etc.

Examples of the amine ligands include pyridine, a trimethylamine ligand, a piperidine ligand, etc.

Examples of the olefin ligands include: chain olefins, such as ethylene and propylene; cyclic olefins, such as cyclopentene, cyclohexene, and norbornene; etc.

### (Polydentate Ligand)

Examples of the polydentate ligand L include ligands derived from hydroxy acid esters, ligands derived from β-diketones, ligands derived from β-keto esters, ligands derived from α,α-dicarboxylic acid esters, hydrocarbons having a π bond, diphosphines, etc.

Examples of the hydroxy acid esters include glycolic acid esters, lactic acid esters, 2-hydroxycyclohexane-1-carboxylic acid esters, salicylic acid esters, etc.

Examples of the β-diketones include acetoacetic acid esters, α-alkyl-substituted acetoacetic acid esters, β-ketopentanoic acid esters, benzoylacetic acid esters, 1,3-acetonedicarboxylic acid esters, etc.

Examples of the β-keto esters include acetoacetic acid esters, α-alkyl-substituted acetoacetic acid esters, β-ketopentanoic acid esters, benzoylacetic acid esters, 1,3-acetonedicarboxylic acid esters, etc.

Examples of the α,α-dicarboxylic acid esters include malonic acid diesters, α-alkyl-substituted malonic acid diesters, α-cycloalkyl-substituted malonic acid diesters, α-aryl-substituted malonic acid diesters, etc.

Examples of the hydrocarbons having a π bond include: chain dienes, such as butadiene and isoprene; cyclic dienes, such as cyclopentadiene, methylcyclopentadiene, pentamethylcyclopentadiene, cyclohexadiene, and norbornadiene; aromatic hydrocarbons, such as benzene, toluene, xylene, hexamethylbenzene, naphthalene, and indene; etc.

Examples of the diphosphines include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino)ferrocene, etc.

The monodentate ligand and the polydentate ligand may contain a crosslinkable group. As the crosslinkable group, the ligand preferably contains any of a vinyl group, an allyl group, an allyloxy group, an ethynyl group, a propargyl group, a propargyloxy group, an epoxy group, and an oxetanyl group. When a metal compound having such a ligand is contained, it is possible to form a metal-containing film excellent in thermosetting property.

Furthermore, the metal compound (M) may be, for example, a compound containing an inorganic anion, such as an anion of an oxoacid (phosphate ion, sulfate ion, chromate ion, tungstate ion (WO₄²⁻), molybdate ion (MoO₄²⁻), etc.) or a polyacid anion, in which multiple oxoacids are condensed, or a mixture thereof.

The polyacid may be an isopolyacid anion (Mm'On')^{c-}or a heteropolyacid anion (Xₗ'Mm'On')^{c-}. In the ionic formulae, M represents a polyatom, X represents a heteroatom, "m'" represents the composition ratio of polyatoms, "n'" represents the composition ratio of oxygen atoms, and "l'" represents the composition ratio of heteroatoms. "c" represents the valence. Examples of the polyatom M include Mo, W, Ti, and Nb. Examples of the heteroatom X include Si, P, As, S, Fe, and Co. A counter cation, such as Na⁺ and H⁺, may be partly contained.

In particular, in view of excellent heat resistance, an anion of an inorganic acid containing at least one of tungsten (W) and molybdenum (Mo) is preferable.

Examples of polyacids containing at least one of tungsten (W) and molybdenum (Mo) include: isopolyacids, such as tungstate ion [W₁₀O₃₂]⁴⁻ and molybdate ion [Mo₆O₁₉]²⁻; heteropolyacids, such as phosphotungstate ion [PW₁₂O₄₀]³⁻, [P₂W₁₈O₆₂]⁶⁻, silicotungstate ion [SiW₁₂O₄₀]⁴⁻, phosphomolybdate ion [PMo₁₂O₄₀]³⁻, silicomolybdate ion [SiMo₁₂O₄₀]⁴⁻, phosphotungstomolybdate ion [PW₁₂₋ₓMoₓO₄₀]³⁻("x" represents an integer of 1 to 11), [P₂W_{18-y}Mo_{y}O₆₂]⁶⁻("y" represents an integer of 1 to 17), silicotungstomolybdate ion [SiW₁₂₋ₓMoₓO₄₀]⁴⁻ ("x" represents an integer of 1 to 11); etc. As the polyacid containing at least one of tungsten (W) and molybdenum (Mo), heteropolyacid is preferable among the above, and furthermore, a heteropolyacid containing phosphorus (P) is more preferable from the viewpoint of heat resistance and from the viewpoint of the availability of raw materials.

Furthermore, any of phosphotungstomolybdate ion [PW₁₀Mo₂O₄₀]³⁻, [PW₁₁Mo₁O₄₀]³⁻, and phosphotungstate ion [PW₁₂O₄₀]³⁻ is further preferable from the viewpoint of heat resistance.

The metal compound (M) may be a hydrolysis product of a metal compound containing a hydrolysable group, a hydrolysis condensate of a metal compound containing a hydrolysable group, or a combination thereof. Here, a "hydrolysis condensation reaction" indicates a reaction in which a hydrolysable group contained in a metal compound hydrolyzes and is converted to -OH, and two -OH groups obtained undergo dehydration condensation to form -O-.

It is also possible to use a compound obtained by subjecting the above-described compounds to a ligand substitution reaction with a material that may become a monodentate ligand or a polydentate ligand, and it is also possible to use a compound obtained by allowing a hydrolysis reaction product of a metal-containing compound having a hydrolysable group or a hydrolysis condensation reaction product of a metal-containing compound having a hydrolysable group to react with a material that may become a monodentate ligand or a polydentate ligand.

Specific examples of the metal compound (M) include the following, but are not limited thereto.

Examples of compounds containing titanium include diisopropoxybis(2,4-pentanedionate)titanium(IV), tetra-n-butoxytitanium(IV), tetra-n-propoxytitanium(IV), titanium tetraisopropoxide(IV), tri-n-butoxymonostearatetitanium(IV), tetrakis(2-ethylhexyl) orthotitanate, dihydroxybis(hydrogen lactato)titanium(IV), titanium(IV)butoxide oligomer, aminopropyltrimethoxytitanium(IV), triethoxymono(2,4-pentanedionate)titanium(IV), tri-n-propoxymono(2,4-pentanedionate)titanium(IV), triisopropoxymono(2,4-pentanedionate)titanium, and di-n-butoxybis(2,4-pentanedionate)titanium(IV).

Examples of compounds containing chromium include chromium(III)tris(2-ethylhexanoate), tris(2,4-pentanedionato)chromium(III), bis(2,2,6,6-tetramethyl-3,5-heptanedionato)chromium(II), tris(trifluoro-2,4-pentanedionato)chromium(III), chromium(III) pyridine-2-carboxylate, chromium(III) chloride, chromium(II) chloride, and chromium(II) cyclohexanecarboxylate.

Examples of compounds containing nickel include nickel(II) acetate, nickel chloride, nickel(II) 2-ethylhexanoate, bis(2,4-pentanedionato)nickel(II) hydrate, bis(hexafluoroacetylacetonato)nickel(II), nickel(II) 2-amino-5-methylbenzenesulfonate, nickel(II) trifluoromethanesulfonate, bis(2,2,6,6-tetramethyl-3,5-heptanedionato)nickel(II), and nickel(II) propionate.

Examples of compounds containing manganese include tris(2,2,6,6-tetramethyl-3,5-heptanedionato)manganese(III).

Examples of compounds containing iron include tris(2,2,6,6-tetramethyl-3,5-heptanedionato)iron(III), iron(II) oxocyclohexanecarboxylate, and iron chloride.

Examples of compounds containing cobalt include dichloro[ethylenebis(diphenylphosphine)]cobalt, cobalt(II) bromide, cobalt(II) acetate, tris(1,3-diphenyl-1,3-propanedione)cobalt(III), and cobalt(II) cyclopentylacetate.

Examples of compounds containing copper include copper(II) acetate, monobutyl phthalate copper(II), copper(II) acetylacetonate, copper(I) heptanoate, and copper(II) 2-ethylhexanoate.

Examples of compounds containing zinc include zinc diisopropoxide, zinc(II) acetate, zinc(II) chloride, and zinc(II) 4-vinylbenzoate.

Examples of compounds containing zirconium include dibutoxybis(ethylacetoacetate)zirconium(IV), di-n-butoxybis(2,4-pentanedionate)zirconium(IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl)ethyltrimethoxyzirconium(IV), γ-glycidoxypropyltrimethoxyzirconium(IV), 3-isocyanopropyltrimethoxyzirconium(IV), triethoxymono(2,4-pentanedionate)zirconium(IV), tri-n-propoxymono(2,4-pentanedionate)zirconium(IV), triisopropoxymono(2,4-pentanedionate) zirconium(IV), tri(3-methacryloxypropyl)methoxyzirconium(IV), tri(3-acryloxypropyl)methoxyzirconium(IV), zirconium(IV) acetate, diacetoxyzirconium(IV) oxide, zirconium(II)bis(2-ethylhexanoate), tetra(2-ethylhexanoic acid)zirconium(IV), bis(2-ethylhexanoic acid)oxozirconium(IV), zirconium nitrate, zirconium(IV) chloride, and zirconium carboxyethyl acrylate (IV).

Examples of compounds containing molybdenum include pentaethoxymolybdenum(V), molybdenum(VI)hexaethoxide, molybdenum(V) isopropoxide, molybdenum(II) acetate dimer, molybdenum(IV) oxide bis(acetylacetonate), molybdenum(VI) oxide bis(2,2,6,6-tetramethyl-3,5-heptanedionate), molybdenum 2-ethylhexanoate, molybdenum(V) chloride, and molybdenum(III) chloride.

Examples of compounds containing indium include tris(1,3-diphenyl-1,3-propanedione)indium(III), indium(III) ethylbutyrate, indium(III) acetate, and indium(III)triisopropoxide.

Examples of compounds containing tin include tin(II) acetate, tin(IV) acetate, tin(II)acetylacetonate, tin(IV) tert-butoxide, tin tetra-n-butoxide, tin tetraisopropoxide, tin(II) 4-fluorobenzeneacetate, and tin(II) 2-ethylhexanoate.

Examples of compounds containing hafnium include diisopropoxybis(2,4-pentanedionate)hafnium(IV), tetrabutoxyhafnium(IV), tetraisopropoxyhafnium(IV), tetraethoxyhafnium(IV), dichlorobis(cyclopentadienyl)hafnium(IV), hafnium(IV) chloride, tetrakis(dimethylamido)hafnium(IV), tetrakis(ethylmethylamido)hafnium(IV), hafnium carboxyethyl acrylate, bis(cyclopentadienyl)hafnium(IV) dichloride, hafnium(IV) trifluoromethanesulfonate hydrate, and hafnium carboxyethyl acrylate (IV).

Examples of compounds containing tantalum include tantalum(V) methoxide, tantalum(V) ethoxide, tetrabutoxytantalum(IV), pentabutoxytantalum(V), pentaethoxytantalum(V), tantalum(V) chloride, pentakis(dimethylamino)tantalum(V), tris(diethylamido)(tert-butylimido)tantalum(V), and bis(2-ethylhexanoic acid) tantalum(II).

Examples of compounds containing tungsten include tungsten(VI) ethoxide, tetrabutoxy tungsten(IV), pentabutoxy tungsten(V), pentamethoxy tungsten(V), hexabutoxy tungsten(VI), hexaethoxy tungsten(VI), and dichlorobis(cyclopentadienyl)tungsten(IV).

Examples of compounds containing bismuth include bismuth(III)-n-butoxide, bismuth(III) tri-t-amiloxide, triethoxybismuth(III), bismuth(III) tris(β-diketonate), bismuth(III) neodecanoate, tris(2-naphthol)bismuth(III), bismuth(III) fluoride, bismuth(III) bromide, bismuth(III) iodide, bismuth(III) oxychloride, bismuth(III) acetate, bismuth(III) subsalicylate, bismuth(III) 2-ethylhexanoate, and bismuth(III) trifluoromethanesulfonate.

### <(B) Solvent>

The solvent (B) usable in the composition for forming a metal-containing film of the present invention is not particularly limited as long as the solvent can dissolve the above-described metal compound (M) and the other additives etc. contained.

Specifically, for example, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents. Examples of other solvents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, methyl isobutyl ketone, cyclopentyl methyl ether, etc.

The solvent (B) is preferably contained in an amount of 200 to 10,000 parts, more preferably 250 to 5,000 parts based on 100 parts by mass of the metal compound (M).

### <Other Additives>

At least one of (C) a crosslinking agent, (D) an acid generator, and (E) a surfactant may be contained in accordance with the purpose of the composition for forming a metal-containing film.

In the following, components that may be contained in the composition for forming a metal-containing film other than the metal compound (M) and the organic solvent (B) will be described.

### [(C) Crosslinking Agent]

When the composition for forming a metal-containing film is to be used for a resist underlayer film, (C) a crosslinking agent can also be contained to increase curability and further inhibit intermixing with a resist upper layer film.

The crosslinking agent is not particularly limited, and various known crosslinking agents can be widely used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agent (C) can be used, or two or more kinds thereof can be used in combination, and when the crosslinking agent is contained, the contained amount is preferably 5 to 50 parts, more preferably 10 to 40 parts based on 100 parts of the metal compound (M). When the contained amount is 5 parts or more, sufficient curability can be exhibited, and intermixing with a resist upper layer film can be suppressed. Meanwhile, when the contained amount is 50 parts or less, there is no risk of degradation in dry etching resistance due to the proportion of the metal compound (M) in the composition being low.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agents include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol-based crosslinking agents include compounds represented by the following general formula (10).

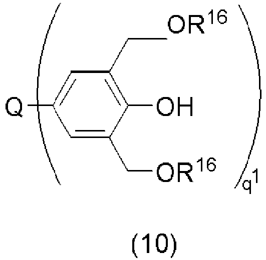

In the formula, Q represents a single bond or a q¹-valent hydrocarbon group having 1 to 20 carbon atoms. R¹⁶ represents a hydrogen atom or an alkyl group having 1 to 20 carbon atoms. "q¹" represents an integer of 1 to 5.

Q represents a single bond or a hydrocarbon group having a valency of "q¹" and having 1 to 20 carbon atoms. "q¹" represents an integer of 1 to 5, more preferably 2 or 3. Specific examples of Q include groups each of which is obtained by removing "q¹" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, or eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

From the viewpoints of enhancing the curability and film thickness uniformity, the compound represented by the general formula (10) is preferably hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene.

### <(D) Acid Generator>

The composition for forming a metal-containing film in the present invention may contain an acid generator, and for example, may contain a compound that generates an acid in response to actinic light or radiation (photo-acid generator).

The photo-acid generator can be any photo-acid generator as long as the compound generates an acid upon high-energy beam irradiation. Suitable photo-acid generators include sulfonium salt, iodonium salt, sulfonyldiazomethane, N-sulfonyloxyimide, oxime-O-sulfonate type acid generators, etc. Specific examples of the acid generator include ones disclosed in paragraphs [0122] to [0142] of JP2008-111103A, JP2009-080474A, and JP2015-026064A.

One kind of the acid generator may be used, or two or more kinds thereof may be used in combination. When the acid generator is contained, the contained amount is preferably 0.05 to 50 parts, more preferably 0.1 to 10 parts based on 100 parts by mass of the metal compound (M) .

### <(E) Surfactant>

A surfactant (E) may be contained in the composition for forming a metal-containing film in order to improve coating property in spin-coating. Examples of the surfactant include those disclosed in [0142] to [0147] of JP2009-269953A. When the surfactant is contained, the contained amount is preferably 0.01 to 10 parts, more preferably 0.05 to 5 parts based on 100 parts by mass of the metal compound (M).

### [Coating Step]

In the coating step, a substrate is coated directly or indirectly with the composition for forming a metal-containing film. Methods for applying the composition for forming a metal-containing film are not particularly limited, and for example, can be performed by an appropriate method, such as spin coating, flow casting, and roll coating. Thus, a coating film is formed, and by the volatilization of the solvent (B) and so forth occurring, a metal-containing film is formed.

The substrate to be coated with the composition for forming a metal-containing film is not particularly limited, and include substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

The lower limit of the average thickness of the formed metal-containing film is preferably 3 nm, more preferably 5 nm, and further preferably 10 nm. The upper limit of the average thickness is preferably 500 nm, more preferably 200 nm, and further preferably 60 nm. Incidentally, the method for measuring the average thickness is as described in the Examples.

The method for manufacturing a semiconductor substrate preferably further includes a step of heating the coating film formed in the coating step (hereinafter, also referred to as a "heating step"). By heating the coating film, the formation of the metal-containing film is promoted. More specifically, the volatilization of the solvent (B) and so forth is promoted by the heating of the coating film.

The heating of the coating film is usually performed in the atmosphere, but can also be performed under a nitrogen atmosphere. The lower limit of the temperature at the heating is preferably 150°C, more preferably 200°C. The upper limit of the temperature is preferably 600°C, more preferably 500°C. The lower limit of the time at the heating is preferably 15 seconds, more preferably 30 seconds. The upper limit of the time is preferably 1,200 seconds, more preferably 600 seconds.

### [Step of Forming Organic Resist Middle Layer Film]

In this step, an organic resist middle layer film can be formed directly or indirectly on the substrate having the metal-containing film formed in the coating step before the resist patterning process.

The organic middle layer film can be formed by applying a composition for forming an organic middle layer film and so forth. Examples of methods for forming an organic resist middle layer film by the application of a composition for forming an organic resist middle layer film include a method including: applying a composition for forming an organic resist middle layer film directly or indirectly on the substrate having the metal-coating film; and curing and so forth the formed coating film by performing heating, exposure, etc.

As the organic resist middle layer film material that can be used for the organic resist middle layer film, it is possible to use: materials already known as materials for an underlayer film for three-layer resist methods or two-layer resist methods using a silicon resist composition; 4,4'-(9-fluorenylidene) bisphenol novolak resin (molecular weight: 11,000) disclosed in JP2005-128509A; and also many resins including novolak resins, known as resist underlayer (or middle layer) film materials for two-layer resist methods and three-layer resist methods. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g. JP2004-153125A).

The organic resist middle layer film can be formed on the substrate to be processed by using a composition solution and by a spin-coating method or the like in the same manner as a photoresist composition. After forming the organic resist middle layer film by a spin-coating method or the like, it is desirable to bake the film in order to evaporate the organic solvent. The baking temperature is preferably 80 to 400°C, and the baking time is preferably 10 to 300 seconds.

Instead of the organic resist middle layer film, it is also possible to adopt an organic hard mask formed by a CVD method or an ALD method.

### [Step of Forming Silicon-Containing Film]

In this step, a silicon-containing film can be formed directly or indirectly on the substrate having the metal-containing film formed in the coating step before the resist patterning process.

The silicon-containing film can be formed by the application of a composition for forming a silicon-containing film, chemical vapor deposition (CVD), atomic layer deposition (ALD), etc. Examples of methods for forming a silicon-containing film by the application of a composition for forming a silicon-containing film include a method including: applying a composition for forming a silicon-containing film directly or indirectly on the metal-containing film; and curing and so forth the formed coating film by exposure and/or heating. As a commercially available product of the composition for forming a silicon-containing film, "SHB-A940" (available from Shin-Etsu Chemical Co., Ltd.) or the like can be used, for example. A silicon oxide film, a silicon nitride film, a silicon oxynitride film, and an amorphous silicon film can be formed by chemical vapor deposition (CVD) or atomic layer deposition (ALD).

### [Cleaning Step]

In this step, the periphery of the substrate is cleaned with a cleaning solution. As the cleaning solution, the inventive cleaning solution described above can be used suitably.

The cleaning method is not particularly limited, and it is possible to adopt a known cleaning method for a semiconductor manufacturing process, for example, edge bead removal, back rinse, etc. In the present invention, the step of cleaning the substrate having the formed metal-containing film preferably includes applying the inventive cleaning solution along the periphery of the substrate and removing the edge bead on the substrate (hereinafter, referred to as "edge rinse" in some cases).

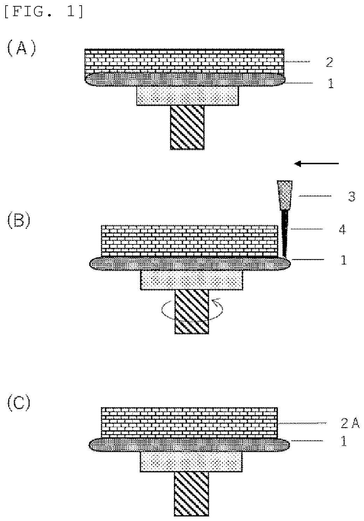

Typically, as shown in FIG. 1, firstly, a substrate 1 having a metal-containing film 2 formed is rotated at a predetermined rate ((A) of FIG. 1). Next, while discharging a cleaning solution 4 from a cleaning solution discharge nozzle 3, the cleaning solution discharge nozzle 3 is moved at a predetermined rate from the peripheral edge of the rotating substrate 1 towards the center of the substrate 1 ((B) of FIG. 1). The movement is stopped when the cleaning solution discharge nozzle 3 has travelled a predetermined distance, and the cleaning solution 4 is further discharged for a predetermined time. After that, the discharging of the cleaning solution 4 from the cleaning solution discharge nozzle 3 is stopped, and by performing drying as necessary, the cleaning of the coating film edge 2A is completed ((C) of FIG. 1). The rotational rate of the substrate, the discharge amount of the cleaning solution per unit time, the movement rate and moved distance of the cleaning solution discharge nozzle, the length of the discharge time of the cleaning solution after the movement of the cleaning solution discharge nozzle is stopped, etc. can be set appropriately depending on the substrate size, the number, types, and thickness of formed films, the cleaned area, etc.

The number of times the edge rinse is performed is not particularly limited, and may be 1 to 20 times. Furthermore, during edge rinsing, two or more kinds of cleaning solution can be applied.

In the edge rinse, the cleaning solution is preferably dropped in an amount of 0.05 to 50 ml, more preferably 0.075 to 40 ml, and further preferably 0.1 to 30 ml.

After applying the composition for forming a metal-containing film to the substrate, the cleaning step can be performed after performing or not performing the heating step. After the coating step, in a case where the cleaning step is performed without going through the heating step, it is preferable to perform the heating step after the cleaning step.

The metal-containing film formed in the above-described step is preferably either a photoresist film or a resist underlayer film.

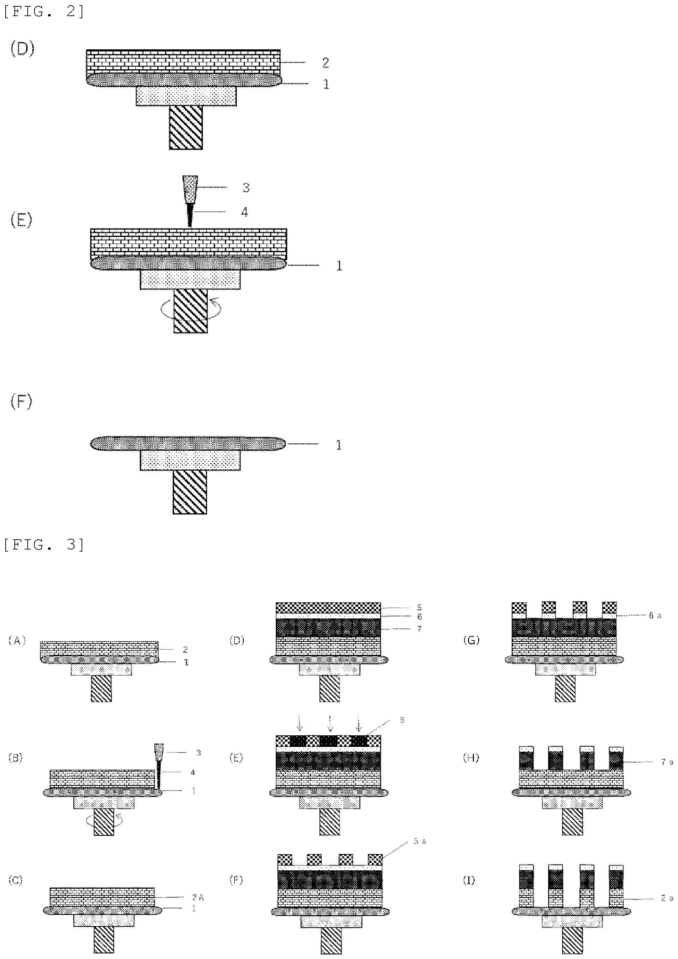

In addition, in the present invention, as shown in FIG. 2, the cleaning solution can also be adopted for reworking the metal-containing film 2 on the substrate 1 to reuse the substrate 1. The cleaning solution discharge nozzle 3 is moved to the center of the substrate 1, and the cleaning solution 4 is discharged onto the rotating substrate 1 for a predetermined time ((D) and (E) of FIG. 2). After that, the discharging of the cleaning solution 4 from the cleaning solution discharge nozzle 3 is stopped, and by performing drying as necessary, the cleaning is completed ((F) of FIG. 2). The rotational rate of the substrate, the discharge amount of the cleaning solution per unit time, the discharge position of the cleaning solution, etc. can be set appropriately depending on the substrate size, the number, types, and thickness of formed films, the cleaned area, etc.

To evaluate the metal-removability by virtue of the edge rinse, residual metal on the substrate can be inspected. A suitable approach commercially available for evaluating trace metal generally includes inductively coupled plasma mass spectrometry (ICP-MS). To evaluate the surface of the substrate, vapor phase decomposition-inductively coupled plasma mass spectrometry (VPD-ICP-MS) can be employed. Using this technology, the residual metal can be determined per unit area of the wafer surface along the edge.

In the present invention, when the metal-containing film is Zr-based, the amount of residual Zr is preferably 100×10¹⁰ atoms/cm² or less, more preferably 50×10¹⁰ atoms/cm² or less, further preferably 10×10¹⁰ atoms/cm² or less, and particularly preferably 5×10¹⁰ atoms/cm² or less.

### <Patterning Process Using Metal-Containing Resist Underlayer Film>

In the resist patterning process, after the cleaning step, a resist pattern is formed directly or indirectly in the metal-containing film. Examples of methods for performing this step include: a method of using a resist composition; a method of using nanoimprinting; and a method of using a self-assembling composition. Examples of cases where the resist pattern is formed in the metal-containing film indirectly include case where the method for manufacturing a semiconductor substrate includes the above-described step of forming silicon-containing film, and the resist pattern is formed on the silicon-containing film.

Examples of methods for forming, after the cleaning step, a resist pattern in the metal-containing film directly or indirectly and transferring the resist pattern to the substrate to be processed include the following.

### (Two-Layer Resist Process)

The present invention can provide, as a patterning process according to a two-layer resist process using a metal-containing film, a patterning process including:
forming a metal-containing film on a substrate to be processed by using a composition for forming a metal-containing film;
forming a resist upper layer film on the metal-containing film by using a photoresist material;
subjecting the resist upper layer film to pattern exposure and then development with a developer to form a pattern in the resist upper layer film;
transferring the pattern to the metal-containing film by dry etching while using the resist upper layer film having the formed pattern as a mask; and
processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas.

To guarantee adhesiveness to the resist upper layer film, an adhesive film may be formed between the resist upper layer film and the metal-containing film. As the adhesive film, an organic film, a silicon-containing film containing polysiloxane, etc. can be used.

### (Three-Layer Resist Process)

The present invention can also provide, as a patterning process according to a three-layer resist process using a metal-containing film, a patterning process including:
forming a metal-containing film on a substrate to be processed by using a composition for forming a metal-containing film;
forming an organic resist middle layer film on the metal-containing film;
forming a resist upper layer film on the organic resist middle layer film by using a photoresist material;
subjecting the resist upper layer film to pattern exposure and then development with a developer to form a pattern in the resist upper layer film;
transferring the pattern to the organic resist middle layer film by dry etching while using the resist upper layer film having the formed pattern as a mask;
transferring the pattern to the metal-containing film by dry etching while using the organic resist middle layer film having the transferred pattern as a mask; and
processing the substrate to be processed while using the metal-containing film having the formed pattern as a mask to form the pattern in the substrate to be processed.

The organic resist middle layer film in the three-layer resist process described above exhibits etching resistance with respect to chlorine-based gas. Therefore, the dry etching of the metal-containing film that is performed while using the organic resist middle layer film as a mask in the three-layer resist process is preferably performed using an etching gas mainly containing a chlorine-based gas.

### (Four-Layer Resist Process)

The present invention can also provide, as a patterning process according to a four-layer resist process using a metal-containing film, a patterning process including:
forming a metal-containing film on a substrate to be processed by using a composition for forming a metal-containing film;
forming an organic resist middle layer film on the metal-containing film;
forming a silicon-containing film on the organic resist middle layer film;
forming a resist upper layer film on the silicon-containing film by using a photoresist material;
subjecting the resist upper layer film to pattern exposure and then development with a developer to form a pattern in the resist upper layer film;
transferring the pattern to the silicon-containing film by dry etching while using the resist upper layer film having the formed pattern as a mask;
transferring the pattern to the organic resist middle layer film by dry etching while using the silicon-containing film having the transferred pattern as a mask;
transferring the pattern to the metal-containing film by dry etching while using the organic resist middle layer film having the transferred pattern as a mask; and
processing the substrate to be processed while using the metal-containing film having the formed pattern as a mask to form the pattern in the substrate to be processed.

Here, a patterning process according to a four-layer resist process will be described with reference to FIG. 3. Firstly, a metal-containing film 2 is formed on a substrate 1 to be processed by using a composition for forming a metal-containing film ((A) of FIG. 3). Subsequently, as described above, a cleaning solution 4 is discharged from a cleaning solution discharge nozzle 3 to clean the metal-containing film 2 on the edge of the substrate ((B) of FIG. 3). Thus, the cleaning of the coating film edge 2A is completed ((C) of FIG. 3). Next, an organic resist middle layer film 7, a silicon-containing film 6, and a resist upper layer film 5 are formed on the metal-containing film 2 ((D) of FIG. 3). An exposure portion 8 of the resist upper layer film 5 is subjected to exposure to form a resist upper layer film pattern 5a ((E) and (F) of FIG. 3). Then, the pattern is transferred to the silicon-containing film 6 by dry etching while using the resist upper layer film pattern 5a as a mask, thus forming a silicon-containing film pattern 6a ((G) of FIG. 3), and subsequently, an organic resist middle layer film pattern 7a and a metal-containing film pattern 2a are formed ((H) and (I) of FIG. 3).

As an inorganic hard mask middle layer film, an inorganic hard mask may be formed. In this case, a semiconductor device circuit pattern can be formed on a substrate, at least, by:
forming a metal-containing film on a body to be processed by using a composition for forming a metal-containing film;
forming an organic resist middle layer film on the metal-containing film;
forming an inorganic hard mask selected from a silicon oxide film, a silicon nitride film, and a silicon oxynitride film on the organic resist middle layer film;
forming a resist upper layer film on the inorganic hard mask by using a photoresist composition;
forming a circuit pattern in the resist upper layer film;
etching the inorganic hard mask while using the resist upper layer film having the formed pattern as a mask;
etching the organic resist middle layer film while using the inorganic hard mask having the formed pattern as a mask;
etching the metal-containing film while using the organic resist middle layer film having the formed pattern as a mask; and
furthermore, etching the body to be processed while using the metal-containing film having the formed pattern as a mask to form the pattern in the body to be processed.

As described above, when the inorganic hard mask is formed on the metal-containing film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most favorably used as the inorganic hard mask. Since the substrate temperature increases to 300 to 500°C when the SiON film is formed, the metal-containing film needs to withstand a temperature of 300 to 500°C. The composition for forming a metal-containing film used in the present invention has high heat resistance and can withstand a high temperature of 300°C to 500°C. Thus, the metal-containing film formed by spin-coating and the inorganic hard mask formed by the CVD method or the ALD method can be combined.

A photoresist film may be formed on the inorganic hard mask as the resist upper layer film as described above. Alternatively, an organic antireflective film (BARC) or an adhesive film may be formed on the inorganic hard mask by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In the above-described patterning process, the resist upper layer film may be either a positive type or a negative type, and it is possible to use a film similar to the typically used photoresist composition.

In a case where the photoresist composition is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, the pattern can be formed using a photolithography with a wavelength of 5 nm or more and 300 nm or less, a direct drawing using an electron beam, nanoimprinting, or a combination thereof, and in the present invention, EUV beam is the most preferable.

The development method in the patterning process is preferably alkali development or development using an organic solvent.

Next, etching is performed while using the obtained resist pattern as a mask. The etching of a silicon-containing resist middle layer film or an inorganic hard mask in the four-layer resist process is performed while using the upper layer resist pattern as a mask by using a fluorocarbon-based gas. In this manner, a silicon-containing resist middle layer film pattern or an inorganic hard mask pattern is formed.

Next, the organic resist middle layer film is etched while using the obtained silicon-containing resist middle layer film pattern or inorganic hard mask pattern as a mask. The etching of the organic resist middle layer film is preferably performed using an etching gas mainly containing an oxygen-based gas.

Next, the metal-containing film is etched while using the obtained organic resist middle layer film pattern as a mask. The etching of the metal-containing film is preferably performed using an etching gas mainly containing a chlorine-based gas.

The subsequent etching of the body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the four-layer resist process is stripped simultaneously with the substrate processing.

In the present invention, the metal-containing film obtained by using the composition for forming a metal-containing film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

### EXAMPLES

The present invention is specifically described below with reference to Synthesis Examples, Examples, and Comparative Examples. However, the present invention is not limited to these Examples.

### <Preparation of Cleaning Solution>

The components were mixed in the proportions shown in Table 1 to prepare each cleaning solution.

**[Table 1]**

| Cleaning solution | First solvent | | Second solvent | | Chelator (C) | | organic acid (G) | |
|---|---|---|---|---|---|---|---|---|
| | Type | Parts by mass | Type | Parts by mass | Structure | Parts by mass | Type | Parts by mass |
| MER-1 | X-1 | 75 | Y-1 | 5 | - | - | G-1 | 20 |
| MER-2 | X-1 | 75 | Y-2 | 5 | - | - | G-1 | 20 |
| MER-3 | X-1 | 75 | Y-3 | 5 | - | - | G-1 | 20 |
| MER-4 | X-1 | 75 | Y-4 | 5 | - | - | G-1 | 20 |
| MER-5 | X-1 | 65 | Y-1 | 15 | - | - | G-1 | 20 |
| MER-6 | X-1 | 65 | Y-3 | 15 | - | - | G-1 | 20 |
| MER-7 | X-1 | 65 | Y-4 | 15 | - | - | G-1 | 20 |
| MER-8 | X-1 | 65 | Y-5 | 15 | - | - | G-1 | 20 |
| MER-9 | X-1 | 65 | Y-6 | 15 | - | - | G-1 | 20 |
| MER-10 | X-1 | 65 | Y-7 | 15 | - | - | G-1 | 20 |
| MER-11 | X-1 | 65 | Y-2 | 15 | - | - | G-2 | 20 |
| MER-12 | X-1 | 65 | Y-2 | 15 | - | - | G-3 | 20 |
| MER-13 | X-1 | 65 | Y-2 | 15 | - | - | G-4 | 20 |
| MER-14 | X-1 | 65 | Y-2 | 15 | - | - | G-5 | 20 |
| MER-15 | X-1 | 65 | Y-2 | 5 | - | - | G-2 | 30 |
| MER-16 | X-1 | 40 | Y-2 | 30 | - | - | G-2 | 30 |
| MER-17 | X-1 | 30 | Y-2 | 40 | - | - | G-2 | 30 |
| MER-18 | X-1 | 45 | Y-2 | 15 | - | - | G-2 | 40 |
| MER-19 | X-1 | 80 | Y-2 | 15 | - | - | G-2 | 5 |
| MER-20 | X-1 | 80 | Y-2 | 18 | - | - | G-2 | 2 |
| MER-21 | X-1 | 70 | Y-2 | 10 | - | - | G-1/G-2 | 10/10 |
| MER-22 | X-2 | 70 | Y-2 | 15 | - | - | G-2 | 15 |
| MER-23 | X-3 | 70 | Y-2 | 15 | - | - | G-2 | 15 |
| MER-24 | X-1 | 63 | Y-6 | 15 | c-1 | 2 | G-1 | 20 |
| MER-25 | X-1 | 63 | Y-7 | 15 | c-2 | 2 | G-1 | 20 |
| Comparative MER-1 | X-1 | 80 | - | 0 | - | - | G-1 | 20 |
| Comparative MER-2 | X-1 | 80 | Y-1 | 20 | - | - | - | 0 |

As the first solvent, the solvents shown in Table 2 below were used.

**[Table 2]**

| First solvent | Type | Boiling point |
|---|---|---|
| X-1 | Propylene glycol monomethyl ether acetate (PGMEA) | 146°C |
| X-2 | Butyl acetate | 126°C |
| X-3 | 2-heptanone | 151°C |

As the second solvent, the solvents shown in Table 3 below were used.

**[Table 3]**

| Second solvent | Type | Boiling point (°C) | Surface tension (mN/m) |
|---|---|---|---|
| Y-1 | 1,6-diacetoxyhexane | 260 | 34.8 |
| Y-2 | Diethylene glycol dibenzoate | 236 | 45.5 |
| Y-3 | Butyl benzoate | 250 | 34.2 |
| Y-4 | Benzyl benzoate | 324 | 43.4 |
| Y-5 | γ-butyrolactone | 204 | 44.8 |
| Y-6 | Diethylene glycol monobenzyl ether | 302 | 42.9 |
| Y-7 | Tripropylene glycol monomethyl ether | 242 | 30.5 |

As the organic acid, the organic acids shown in Table 4 below were used.

**[Table 4]**

| Organic acid | Type |
|---|---|
| G-1 | Acetic acid |
| G-2 | Formic acid |
| G-3 | Citric acid |
| G-4 | Acrylic acid |
| G-5 | Propionic acid |

As a chelator (c-1), acetylacetone (P0052 available from Tokyo Chemical Industry Co., Ltd.) was used, and as a chelator (c-2), allyl acetoacetate (A1981 available from Tokyo Chemical Industry Co., Ltd.) was used.

### <Preparation of Compositions for Forming Metal-Containing Film>

### [Synthesis Example of Metal Compound]

In the following Synthesis Examples, the metal source M ((M1) to (M3)) and the compound group H ((H1) to (H3)) shown below were used.
(M1): Ti(OBu)₄: tetrabutyl orthotitanate (B0742 available from Tokyo Chemical Industry Co., Ltd.)
(M2): Hf(OBu)₄: hafnium(IV) n-butoxide (667943 available from Sigma-Aldrich Corp)
(M3): Zr(OBu)₄: zirconium(IV) tetrabutoxide (80 mass% solution in 1-butanol) (Z0016 available from Tokyo Chemical Industry Co., Ltd.)

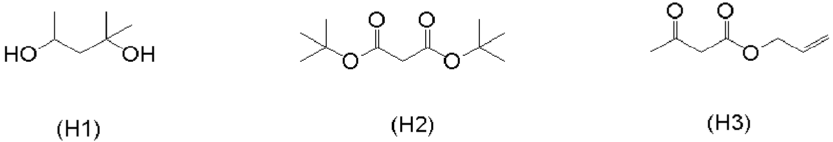

### [Synthesis Example 1: Synthesis of Metal Compound (m-1) for Forming Metal-Containing Film]

Under a nitrogen atmosphere, into 40.5 g of a solution of 28.4 g of tetrabutyl orthotitanate (M1) in n-butanol, while stirring, 54.5 g of a solution of 1.6 g of deionized water in n-butanol was added dropwise at room temperature over 2 hours. To the obtained solution, 11.2 g of the compound group (H1) was added, and the mixture was agitated at room temperature for 30 minutes. After the solution was concentrated under reduced pressure at 30°C, it was further heated to 60°C and heating was continued under reduced pressure to generate no distillate. When a distillate was no longer observed, 69.0 g of a PGMEA/PGME (ratio by weight: 70/30) solution was added thereto and heated under reduced pressure at 40°C until no isopropanol (IPA) was distilled. Thus, a solution of a metal compound (m-1) for forming a metal-containing film in PGMEA/PGME was obtained. The concentration of the components in the solution other than the solvent was 17% by mass.

### [Synthesis of Compounds (m-2) and (m-3)]

The compounds (m-2) and (m-3) shown in Table 5 were obtained under the same reaction conditions as in Synthesis Example 1, except that the metal source M and the compound group H were used at the charging amounts shown in Table 5.

**[Table 5]**

| Synthesis Example | Metal source M | | Compound group H | | Compound |
|---|---|---|---|---|---|
| | Starting material | g | Starting material | g | |
| 1 | M1 | 28.4 | H1 | 11.2 | m-1 |
| 2 | M2 | 54.9 | H2 | 25.1 | m-2 |
| 3 | M3 | 57.5 | H3 | 17.4 | m-3 |

### [Preparation of Compound (m-4)]

As a metal compound (m-4), tin(II) 2-ethylhexanoate (T3149 available from Tokyo Chemical Industry Co., Ltd.) was used.

### [Preparation of Composition (MUL-1) for Forming Metal-Containing Film]

The compound (m-1) for forming a metal-containing film was dissolved in a mixed solvent of propylene glycol monomethyl ether acetate (PGMEA) and propylene glycol monomethyl ether (PGME) in the proportion shown in Table 6, and the solution was filtered through a 0.02-µm membrane filter to prepare a composition (MUL-1) for forming a metal-containing film.

### [Preparation of Compositions (MUL-2 to -4) for Forming Metal-Containing Film]

Each chemical liquid was prepared in the same manner as MUL-1, except that the type and the contained amount of each component were as shown in Table 6.

**[Table 6]**

| Composition for forming metal-containing film | Metal compound | | Solvent | |
|---|---|---|---|---|
| | Type | Parts by mass | Type | Parts by mass |
| MUL-1 | m-1 | 10.0 | PGMEA/PGME | 70/20 |
| MUL-2 | m-2 | 10.0 | PGMEA/PGME | 70/20 |
| MUL-3 | m-3 | 10.0 | PGMEA/PGME | 70/20 |
| MUL-4 | m-4 | 15.0 | PGEE | 65/20 |

### <Evaluation of Metal-Cleaning Property>

Each of the compositions (MUL-1 to -4) for forming a metal-containing film prepared above was respectively applied onto a silicon substrate by spin-coating. Then, while rotating the substrate at 1500 rpm, a cleaning solution (MER-1 to -25 and comparative MER-1 and -2) was discharged at a discharge rate of 2 ml/second while moving the cleaning solution discharge nozzle from the peripheral edge of the substrate to a position shifted by 2 mm towards the center of the substrate, and the cleaning solution was discharged at a discharge rate of 2 ml/second for 10 seconds in the position 2 mm from the peripheral edge of the substrate towards the center of the substrate. Then, the substrate was rotated at 1500 rpm for 30 seconds. Subsequently, the substrate was heated at 450°C for 60 seconds to obtain a substrate A for evaluation having a formed metal-containing film having an average thickness of 30 nm. Subsequently, using vapor phase decomposition-inductively coupled plasma mass spectrometry (VPD-ICP-MS), the amount (×10¹⁰ atoms/cm²) of residual metal in the peripheral edge (the front and back surface regions 0.3 mm from the edge) of the obtained substrate A for evaluation was measured.

Substrates B for evaluation each respectively having each of the formed metal-containing films having an average thickness of 30 nm were obtained by the same procedure as when obtaining the substrate A for evaluation except that OK73 thinner was used instead of the cleaning solutions (MER-1 to -25) as the cleaning solution. OK73 thinner is a mixed solvent of propylene glycol monomethyl ether and propylene glycol methyl ether acetate.

The metal-cleaning property was evaluated as "A" when the amount of metal contained in the metal compound for forming a metal-containing film detected from the substrate A for evaluation was less than 30% relative to the substrate B for evaluation, as "B" when 30% or more and less than 50%, and as "C" when 50% or more. The results are shown in Table 7.

**[Table 7]**

| Example | Composition for forming metal-containing film | Cleaning solution | Analyzed metal | Amount of residual metal |
|---|---|---|---|---|
| | | | | atoms/cm² |
| Example 1-1 | MUL-1 | MER-1 | Ti | B |
| Example 1-2 | MUL-2 | MER-2 | Hf | A |
| Example 1-3 | MUL-3 | MER-3 | Zr | A |
| Example 1-4 | MUL-4 | MER-4 | Sn | A |
| Example 1-5 | MUL-3 | MER-5 | Zr | B |
| Example 1-6 | MUL-3 | MER-6 | Zr | A |
| Example 1-7 | MUL-3 | MER-7 | Zr | A |
| Example 1-8 | MUL-3 | MER-8 | Zr | B |
| Example 1-9 | MUL-3 | MER-9 | Zr | B |
| Example 1-10 | MUL-3 | MER-10 | Zr | B |
| Example 1-11 | MUL-3 | MER-11 | Zr | A |
| Example 1-12 | MUL-3 | MER-12 | Zr | A |
| Example 1-13 | MUL-3 | MER-13 | Zr | A |
| Example 1-14 | MUL-3 | MER-14 | Zr | A |
| Example 1-15 | MUL-3 | MER-15 | Zr | B |
| Example 1-16 | MUL-3 | MER-16 | Zr | A |
| Example 1-17 | MUL-3 | MER-17 | Zr | A |
| Example 1-18 | MUL-3 | MER-18 | Zr | A |
| Example 1-19 | MUL-3 | MER-19 | Zr | B |
| Example 1-20 | MUL-3 | MER-20 | Zr | B |
| Example 1-21 | MUL-3 | MER-21 | Zr | A |
| Example 1-22 | MUL-3 | MER-22 | Zr | A |
| Example 1-23 | MUL-3 | MER-23 | Zr | A |
| Example 1-24 | MUL-3 | MER-24 | Zr | A |
| Example 1-25 | MUL-3 | MER-25 | Zr | A |
| Comparative Example 1-1 | MUL-3 | Comparative MER-1 | Zr | C |
| Comparative Example 1-2 | MUL-3 | Comparative MER-2 | Zr | C |

As shown in Table 7, it was shown that the inventive cleaning solutions had better metal-cleaning property than those in Comparative Example 1-1 and Comparative Example 1-2, where comparative MER-1 and -2 were used. The inventive cleaning solutions each contain a second solvent (A-2), having a normal boiling point of 160°C or higher and lower than 500°C, and it is conjectured that the drying of the cleaning solution was therefore suppressed and the metal-cleaning effect of the organic acid was further enhanced. The cleaning solution containing, among the second solvents, a chain carboxylate ester or a chain ether containing no hydroxy groups (Y-2 to -4) exhibited excellent metal-removability. This is conjectured to be because, by using an organic solvent containing no hydroxy groups, the esterification reaction of the acid in the cleaning solution was suppressed, and degradation in the metal-removability of the cleaning solution was successfully suppressed. Meanwhile, in Examples 1-24 and 1-25, where cleaning solutions MER-24 and -25 containing compounds (c-1) and (c-2) containing a β-diketone structure were used as chelators, better cleaning property was exhibited than in Examples 1-9 and 1-10, where cleaning solutions MER-9 and -10 containing no chelators was used.

### <Waste Liquid Stability>

Mixed solutions were prepared by mixing each of the cleaning solutions (MER-1 to -25) prepared above with equal amounts of one of the compositions (MUL-1 to -4) for forming a metal-containing film, a composition (SOC-1) for forming a resist underlayer film, a composition (SOG-1) for forming a silicon-containing film, and a photoresist composition (PR-1), and it was visually observed whether or not there was a precipitate or clouding after leaving to stand at 23°C for one week. The waste liquid stability was evaluated as "Good" when there was no precipitation or clouding after leaving the prepared mixed solution to stand at 23°C for one week, and as "Poor" when there was precipitation or clouding. The results are shown in Table 12.

As the composition (SOC-1) for forming a resist underlayer film, the composition (SOG-1) for forming a silicon-containing film, and the photoresist composition (PR-1), the following materials were used.

The composition (SOC-1) for forming a resist underlayer film was prepared by dissolving a polymer represented by the organic underlayer film polymer (SOP1) in an organic solvent containing 0.1 mass% of FC-4430 (available from Sumitomo 3M Limited) in the proportion shown in Table 8; and filtering the solution through a filter made of a fluororesin and having a pore size of 0.2 µm.

**[Table 8]**

| | Organic underlayer film polymer | Organic solvent |
|---|---|---|
| | (parts by mass) | (parts by mass) |
| SOC-1 | SOP1 (7) | PGMEA (93) |

The structural formula of the used organic underlayer film polymer (SOP1) is shown in Table 9.

**[Table 9]**

| Compound or polymer | Mw | Mw /Mn |
|---|---|---|
| 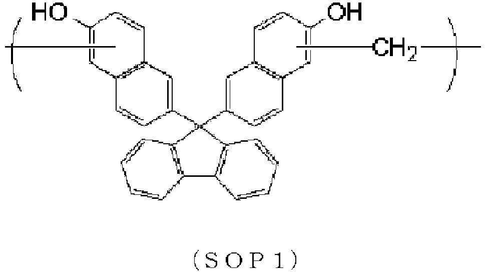 | 3, 700 | 2.82 |

The composition (SOG-1) for forming a silicon-containing film was prepared by dissolving a polymer represented by the silicon-containing middle layer film polymer (SiP1) and a thermal crosslinking catalyst (CAT1) in an organic solvent containing 0.1 mass% of FC-4430 (available from Sumitomo 3M Limited) in the proportion shown in Table 10; and filtering the solution through a filter made of a fluororesin and having a pore size of 0.1 µm.

**[Table 10]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4000) |

The structural formulae of the used silicon-containing middle layer film polymer (SiP1) and thermal crosslinking catalyst (CAT1) are shown below.

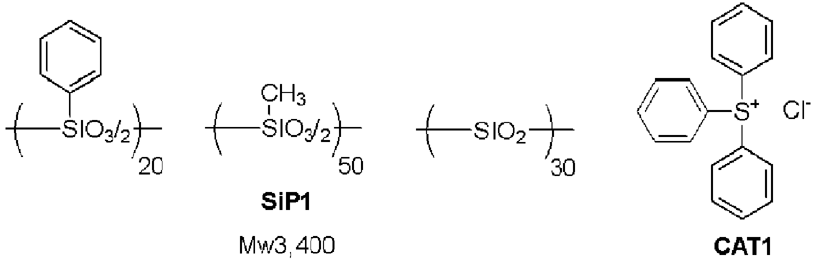

The photoresist composition (PR-1) was prepared by dissolving the polymer shown below, a quencher, a sensitizer, and a surfactant in an organic solvent containing 0.25 mass% of FC-4430 (available from Sumitomo 3M Limited) in the proportion shown in Table 11; and filtering the solution through a filter made of a fluororesin and having a pore size of 0.1 µm.

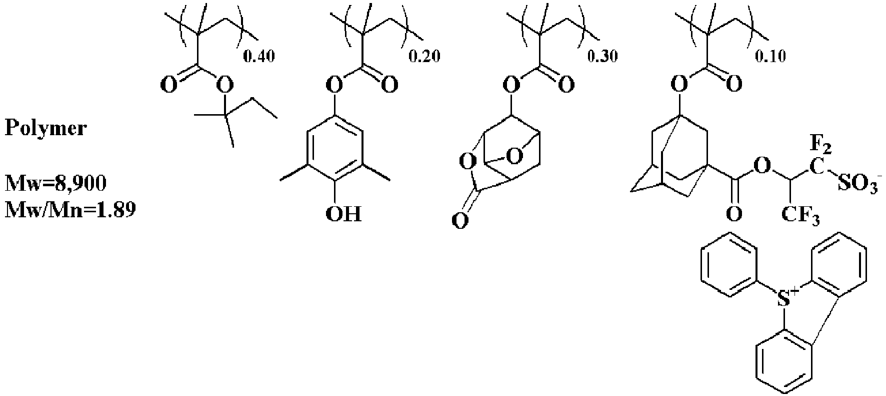

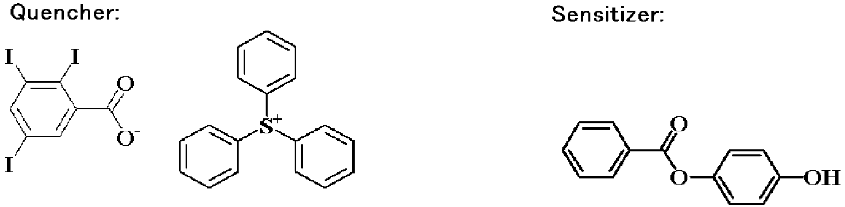

### Surfactant: FC-4430 available from 3M Company

**[Table 11]**

| Component | Polymer | Quencher | Sensitizer | Surfactant | Organic solvent |
|---|---|---|---|---|---|
| Composition (parts by mass) | (100) | (4.0) | (2.1) | (0.25) | PGMEA (400) |
| | | | | | CyHO (2000) |
| | | | | | PGME (100) |

| | | | | | |
|---|---|---|---|---|---|
| • Organic solvents: PGMEA (propylene glycol monomethyl ether acetate) CyHO (cyclohexanone) PGME (propylene glycol monomethyl ether) | | | | | |

**[Table 12]**

| Example | Cleaning solution | Composition for forming metal-containing film | | Composition for forming resist underlayer film | | Composition for forming silicon-containing film | | Photoresist composition | |
|---|---|---|---|---|---|---|---|---|---|
| | | Material | Stability | Material | Stability | Material | Stability | Material | Stability |
| Example 2-1 | MER-1 | MUL-1 | Good | SOC-1 | Good | SOG-1 | Good | PR-1 | Good |
| Example 2-2 | MER-2 | MUL-2 | Good | SOC-1 | Good | SOG-1 | Good | PR-1 | Good |
| Example 2-3 | MER-3 | MUL-3 | Good | SOC-1 | Good | SOG-1 | Good | PR-1 | Good |
| Example 2-4 | MER-4 | MUL-4 | Good | SOC-1 | Good | SOG-1 | Good | PR-1 | Good |
| Example 2-5 | MER-5 | MUL-1 | Good | SOC-1 | Good | SOG-1 | Good | PR-1 | Good |
| Example 2-6 | MER-6 | MUL-2 | Good | SOC-1 | Good | SOG-1 | Good | PR-1 | Good |
| Example 2-7 | MER-7 | MUL-3 | Good | SOC-1 | Good | SOG-1 | Good | PR-1 | Good |
| Example 2-8 | MER-8 | MUL-4 | Good | SOC-1 | Good | SOG-1 | Good | PR-1 | Good |
| Example 2-9 | MER-9 | MUL-1 | Good | SOC-1 | Good | SOG-1 | Good | PR-1 | Good |
| Example 2-10 | MER-10 | MUL-2 | Good | SOC-1 | Good | SOG-1 | Good | PR-1 | Good |
| Example 2-11 | MER-11 | MUL-3 | Good | SOC-1 | Good | SOG-1 | Good | PR-1 | Good |
| Example 2-12 | MER-12 | MUL-4 | Good | SOC-1 | Good | SOG-1 | Good | PR-1 | Good |
| Example 2-13 | MER-13 | MUL-1 | Good | SOC-1 | Good | SOG-1 | Good | PR-1 | Good |
| Example 2-14 | MER-14 | MUL-2 | Good | SOC-1 | Good | SOG-1 | Good | PR-1 | Good |
| Example 2-15 | MER-15 | MUL-3 | Good | SOC-1 | Good | SOG-1 | Good | PR-1 | Good |
| Example 2-16 | MER-16 | MUL-4 | Good | SOC-1 | Good | SOG-1 | Good | PR-1 | Good |
| Example 2-17 | MER-17 | MUL-1 | Good | SOC-1 | Good | SOG-1 | Good | PR-1 | Good |
| Example 2-18 | MER-18 | MUL-2 | Good | SOC-1 | Good | SOG-1 | Good | PR-1 | Good |
| Example 2-19 | MER-19 | MUL-3 | Good | SOC-1 | Good | SOG-1 | Good | PR-1 | Good |
| Example 2-20 | MER-20 | MUL-4 | Good | SOC-1 | Good | SOG-1 | Good | PR-1 | Good |
| Example 2-21 | MER-21 | MUL-1 | Good | SOC-1 | Good | SOG-1 | Good | PR-1 | Good |
| Example 2-22 | MER-22 | MUL-2 | Good | SOC-1 | Good | SOG-1 | Good | PR-1 | Good |
| Example 2-23 | MER-23 | MUL-3 | Good | SOC-1 | Good | SOG-1 | Good | PR-1 | Good |
| Example 2-24 | MER-24 | MUL-4 | Good | SOC-1 | Good | SOG-1 | Good | PR-1 | Good |
| Example 2-25 | MER-25 | MUL-1 | Good | SOC-1 | Good | SOG-1 | Good | PR-1 | Good |

As shown in the results of Table 12, it was found that the inventive cleaning solutions were excellent in waste liquid stability.

### <Evaluation of Hump Height>

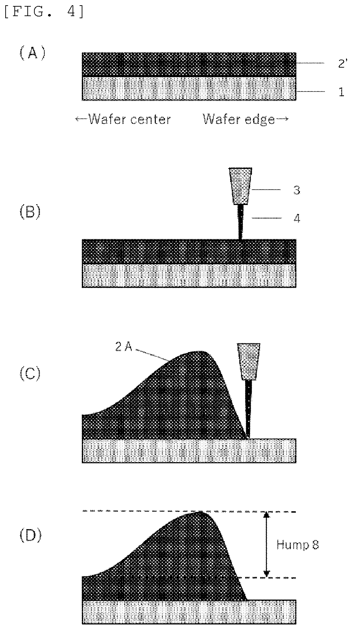

As shown in FIG. 4, each of the compositions 2' (MUL-1 to -4) for forming a metal-containing film prepared above was respectively applied onto a silicon substrate 1 by spin-coating ((A) of FIG. 4). Then, while rotating the substrate at 1500 rpm, each of the cleaning solutions 4 (MER-1 to -25 and comparative MER-1 and -2) was respectively discharged at a discharge rate of 2 ml/second while moving the cleaning solution discharge nozzle 3 from the peripheral edge of the substrate to a position shifted by 2 mm towards the center of the substrate ((B) of FIG. 4), and the cleaning solution was discharged at a discharge rate of 2 ml/second for 10 seconds in the position 2 mm from the peripheral edge of the substrate towards the center of the substrate ((C) of FIG. 4). Then, the substrate was rotated at 1500 rpm for 30 seconds. Subsequently, the substrate was heated at 450°C for 60 seconds to obtain a substrate A for evaluation having a formed metal-containing film having an average thickness of 30 nm. Subsequently, the height of the bulge (hump) (Hump 8 of FIG. 4 (D)) of the coating film edge 2A, being near the border of the region where the film was removed, was measured with a stylus profiler (apparatus name "Alpha Step", manufactured by KLA-Tencor).

Substrates B for evaluation each respectively having each of the formed metal-containing films having an average thickness of 30 nm were obtained by the same procedure as when obtaining the substrate A for evaluation except that OK73 thinner was used instead of the cleaning solutions (MER-1 to -25) as the cleaning solution.

The evaluation "A" was given when the height of the hump of the substrate A for evaluation was less than 50% of that of the substrate B for evaluation, "B" when 50 to 80%, and when more than 80%, "C". The results are shown in Table 13.

**[Table 13]**

| Example | Cleaning solution | Hump height |
|---|---|---|
| Example 3-1 | MER-1 | A |
| Example 3-2 | MER-2 | A |
| Example 3-3 | MER-3 | A |
| Example 3-4 | MER-4 | A |
| Example 3-5 | MER-5 | A |
| Example 3-6 | MER-6 | A |
| Example 3-7 | MER-7 | A |
| Example 3-8 | MER-8 | A |
| Example 3-9 | MER-9 | A |
| Example 3-10 | MER-10 | B |
| Example 3-11 | MER-11 | A |
| Example 3-12 | MER-12 | A |
| Example 3-13 | MER-13 | A |
| Example 3-14 | MER-14 | A |
| Example 3-15 | MER-15 | B |
| Example 3-16 | MER-16 | A |
| Example 3-17 | MER-17 | A |
| Example 3-18 | MER-18 | A |
| Example 3-19 | MER-19 | A |
| Example 3-20 | MER-20 | A |
| Example 3-21 | MER-21 | A |
| Example 3-22 | MER-22 | A |
| Example 3-23 | MER-23 | A |
| Example 3-24 | MER-24 | A |
| Example 3-25 | MER-25 | B |
| Comparative Example 1-1 | Comparative MER-1 | C |
| Comparative Example 1-2 | Comparative MER-2 | B |

As shown in the results of Table 13, it was shown that the inventive cleaning solutions were capable of suppressing the hump height compared to the OK73 thinner. In particular, the cleaning solutions (e.g. MER-1 to -9) containing second solvents (Y-1) to (Y-6), having a high surface tension, exhibited excellent hump suppression property. On the other hand, no improvement in the hump was observed in the case of comparative MER-1, not containing a second solvent. Comparative MER-2, which contained a second solvent (Y-1) but contained no organic acid, resulted in poor hump suppression property compared to MER-5, which contained an organic acid. That is, it can be considered that, when the organic acid is contained, compatibility with the metal-containing film increases and the hump suppression property is enhanced. It can be considered that, since the inventive cleaning solutions contained the component of the second solvent having a normal boiling point of 160°C or higher and lower than 500°C in addition to the organic acid, a synergistic effect took place, and excellent hump suppression property was exhibited.

As described above, the inventive cleaning solution contains (A) a solvent and (B) an organic acid, and the solvent (A) contains at least one kind of a first solvent (A-1) having a normal boiling point of lower than 160°C and at least one kind of a second solvent (A-2) having a normal boiling point of 160°C or higher and lower than 500°C. Therefore, it is possible to provide a cleaning solution excellent in cleaning property, such as removal of a composition for forming a metal-containing film on the periphery of a substrate, hump suppression property, and waste liquid stability when the composition for forming a metal-containing film has been applied to the substrate. According to a method for cleaning a substrate by using the cleaning solution and a method for forming a metal-containing film by using the cleaning solution, a cleaning solution excellent in cleaning property, hump suppression property, and waste liquid stability is used, and therefore, the desired resist underlayer film can be formed efficiently. These can be used suitably in the production of semiconductor devices and so forth, which are expected to be further miniaturized in the future.

The present description includes the following inventions.
[1]: A cleaning solution for a composition for forming a metal-containing film, the cleaning solution comprising:
   (A) a solvent; and (B) an organic acid,
      wherein the solvent (A) contains at least one kind of a first solvent (A-1) having a normal boiling point of lower than 160°C and at least one kind of a second solvent (A-2) having a normal boiling point of 160°C or higher and lower than 500°C.
[2]: The cleaning solution of [1], wherein the second solvent (A-2) is a chain ester, a chain ether, or a combination thereof.
[3]: The cleaning solution of [2], wherein the ester is a carboxylate ester.
[4]: The cleaning solution of [2] or [3], wherein the ether is a (poly)alkylene glycol dibenzyl ether or a (poly)phenyl ether.
[5]: The cleaning solution of any one of [1] to [4], wherein the second solvent (A-2) has a surface tension of 29.0 mN/m or more.
[6]: The cleaning solution of any one of [1] to [5], wherein, in the solvent (A), the first solvent (A-1) is contained in an amount of 30 mass% or more and 98 mass% or less and the second solvent (A-2) is contained in an amount of 2 mass% or more and 70 mass% or less.
[7]: The cleaning solution of any one of [1] to [6], wherein the organic acid (B) is a carboxylic acid.
[8]: The cleaning solution of any one of [1] to [7], wherein the organic acid (B) is contained in an amount of 1 to 70 mass% based on an entire mass of the cleaning solution.
[9]: The cleaning solution of any one of [1] to [8], further comprising, as (C) a chelator, a compound having a β-diketone.
[10]: The cleaning solution of [9], wherein the chelator (C) is contained in an amount of 0.1 to 10 mass% based on an entire mass of the cleaning solution.
[11]: A method for cleaning a substrate comprising a step of cleaning, regarding a substrate coated directly or indirectly with a composition for forming a metal-containing film, the composition for forming a metal-containing film on a periphery of the substrate by using the cleaning solution of any one of [1] to [10].
[12]: A method for forming a metal-containing film, comprising the steps of:
   coating a substrate directly or indirectly with a composition for forming a metal-containing film; and
   cleaning the composition for forming a metal-containing film on a periphery of the substrate by using the cleaning solution of any one of [1] to [10],
   wherein the composition for forming a metal-containing film contains a metal compound and a solvent.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A cleaning solution for a composition for forming a metal-containing film, the cleaning solution comprising:
(A) a solvent; and (B) an organic acid,
wherein the solvent (A) contains at least one kind of a first solvent (A-1) having a normal boiling point of lower than 160°C and at least one kind of a second solvent (A-2) having a normal boiling point of 160°C or higher and lower than 500°C.

2. The cleaning solution according to claim 1, wherein the second solvent (A-2) is a chain ester, a chain ether, or a combination thereof.

3. The cleaning solution according to claim 2, wherein the ester is a carboxylate ester.

4. The cleaning solution according to claim 2, wherein the ether is a (poly)alkylene glycol dibenzyl ether or a (poly)phenyl ether.

5. The cleaning solution according to claim 1, wherein the second solvent (A-2) has a surface tension of 29.0 mN/m or more.

6. The cleaning solution according to claim 1, wherein, in the solvent (A), the first solvent (A-1) is contained in an amount of 30 mass% or more and 98 mass% or less and the second solvent (A-2) is contained in an amount of 2 mass% or more and 70 mass% or less.

7. The cleaning solution according to claim 1, wherein the organic acid (B) is a carboxylic acid.

8. The cleaning solution according to claim 1, wherein the organic acid (B) is contained in an amount of 1 to 70 mass% based on an entire mass of the cleaning solution.

9. The cleaning solution according to claim 1, further comprising, as (C) a chelator, a compound having a β-diketone.

10. The cleaning solution according to claim 9, wherein the chelator (C) is contained in an amount of 0.1 to 10 mass% based on an entire mass of the cleaning solution.

11. A method for cleaning a substrate comprising a step of cleaning, regarding a substrate coated directly or indirectly with a composition for forming a metal-containing film, the composition for forming a metal-containing film on a periphery of the substrate by using the cleaning solution according to any one of claims 1 to 10.

12. A method for forming a metal-containing film, comprising the steps of:
coating a substrate directly or indirectly with a composition for forming a metal-containing film; and
cleaning the composition for forming a metal-containing film on a periphery of the substrate by using the cleaning solution according to any one of claims 1 to 10,
wherein the composition for forming a metal-containing film contains a metal compound and a solvent.
